(19) Europäisches Patentamt
European Patent Office
Office européen des brevets

(11) **EP 4 144 631 B1**

(12) **EUROPEAN PATENT SPECIFICATION**

(45) Date of publication and mention
of the grant of the patent:
**21.05.2025 Bulletin 2025/21**

(21) Application number: **21894357.9**

(22) Date of filing: **07.10.2021**

(51) International Patent Classification (IPC):
**B63B 79/10** (2020.01)    **B63B 79/20** (2020.01)
**B63B 79/30** (2020.01)

(52) Cooperative Patent Classification (CPC):
**B63B 79/10; B63B 79/20; B63B 79/30**

(86) International application number:
**PCT/JP2021/037224**

(87) International publication number:
**WO 2022/107482 (27.05.2022 Gazette 2022/21)**

(54) **ESTIMATION DEVICE, ESTIMATION METHOD, AND PROGRAM**

SCHÄTZVORRICHTUNG, SCHÄTZVERFAHREN UND PROGRAMM

DISPOSITIF D'ESTIMATION, PROCÉDÉ D'ESTIMATION ET PROGRAMME

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **18.11.2020 JP 2020191656**

(43) Date of publication of application:
**08.03.2023 Bulletin 2023/10**

(73) Proprietor: **Mitsubishi Shipbuilding Co., Ltd.**
**Yokohama-shi**
**Kanagawa 220-8401 (JP)**

(72) Inventors:
• **SUGIMURA Tadashi**
**Tokyo 100-8332 (JP)**
• **MATSUMOTO Shunsaku**
**Tokyo 100-8332 (JP)**
• **INOUE Soichiro**
**Yokohama-shi, Kanagawa 220-8401 (JP)**
• **TERADA Shin**
**Yokohama-shi, Kanagawa 220-8401 (JP)**
• **MIYAZAKI Satoshi**
**Yokohama-shi, Kanagawa 220-8401 (JP)**

(74) Representative: **Studio Torta S.p.A.**
**Via Viotti, 9**
**10121 Torino (IT)**

(56) References cited:
WO-A1-2016/108183    JP-A- 2013 124 015
JP-A- 2018 509 327    JP-A- 2020 083 125

• HULKKONEN TAPIO, TEEMU MANDERBACKA ,
KEI SUGIMOTO: "Digital Twin for Monitoring
Remaining Fatigue Life of Critical Hull
Structures", CONFERENCE PAPER, 1 March
2019 (2019-03-01), pages 415 - 427, XP055931726
• ANONYMOUS: "Research and Development of
Ultra-High Precision Hull Structure Digital Twin
2019", RESEARCH AND DEVELOPMENT OF
ULTRA-HIGH PRECISION HULL STRUCTURE
DIGITAL TWIN 2019 ACHIEVEMENT REPORT
SUMMARY VERSION, 1 March 2020 (2020-03-01),
JP, pages 1 - 27, XP009537279
• MIYASHITA TETSUJI, OKADA TETSUO,
KAWAMURA, YASUMI, SEKI NORIAKI, HANADA
RYO: "simple estimation method of fatigue
strength considering the elastic vibration
response that occurs in a large container ship",
PROCEEDINGS OF JAPAN SOCIETY OF NAVAL
ARCHITECTS, vol. 31, 1 June 2020 (2020-06-01),
pages 123 - 124, XP055931731, ISSN: 1880-3717,
DOI: 10.2534/jjasnaoe.31.123

- OKADA, TETSUO, KAWAMURA, YASUMI, KATO, JUN, ANDO, HIDEYUKI, YONEZAWA, TAKASHI, KIMURA, FUMITAKA, TOYODA, MASANOBU, YAMAUCHI, AKIHI: "Outline of the research project on hull structure health monitoring of 14,000TEU large container ships", CONFERENCE PROCEEDINGS, THE JAPAN SOCIETY OF NAVAL ARCHITECTS AND OCEAN ENGINEERS, vol. 24, 1 May 2017 (2017-05-01), JP, pages 31 - 35, XP009536953, ISSN: 2185-1840
- YOSHIHIRA, YUKI, OKADA, TETSUO, KAWAMURA, YASUMI, TERADA, YUKI: "A study on the estimation method of an ocean wave spectrum using measured hull responses on 14,000TEU large container ships", CONFERENCE PROCEEDINGS OF THE ANNUAL SPRING MEETING 2017; JAPAN SOCIETY OF NAVAL ARCHITECTS AND OCEAN ENGINEERS; MAY 23-24, 2017, vol. 24, 1 May 2017 (2017-05-01) - 24 May 2017 (2017-05-24), JP, pages 37 - 42, XP009536952, ISSN: 2185-1840

**Description**

Technical Field

The present disclosure relates to an estimation device, an estimation method, and a program for estimating a response from a structure at an unmeasured point. The present disclosure claims priority based on Japanese Patent Application No. 2020-191656 filed in Japan on November 18, 2020.

Background Art

There has been an increase in the number of industries using floating facilities, such as expansion of the production of offshore oil and gas using a floating production, storage and offloading system (FPSO) and use of offshore wind turbines. These floating structures need to be secured and operated in a sea area where they are installed for a long period of time. Thus, the structures cannot be periodically docked for inspection and repair, like marine vessels can. Currently, the outer circumference inspection has been performed under the sea, and partial in-tank inspection has been performed, about once in five years. Such inspections include visual inspection and measurement on the plate thickness of representative points. This is nothing more than an evaluation on a state at the point of the inspection, meaning that the remaining service life for the long service period thereafter cannot be quantitatively figured out with the inspection. A structure model can be used for estimating a load acting based on statistical data, obtain a structural response, and calculate fatigue harm using the result of these. Still, this is a simple estimation based on the initial state of the floating structure, that is, an estimation not taking the current state of the floating structure into consideration. Thus, the remaining service life cannot be quantitatively determined while taking the actual operation state and aging into consideration.

The actual operation state of a floating structure is monitored by monitoring a value measured by sensors attached to the floating structure. However, the sensors can only be attached to an outer surface and a dry region of the floating structure such as an upper deck, meaning that an internal structure and a member on a tank inner surface that are typical critical areas cannot be directly sensed. To monitor the state of a critical area, a structural response needs to be calculated using a digital twin that is a virtual replica of the floating structure. Unfortunately, sufficient accuracy cannot be fully achieved with the state of art.

Patent Document 1 discloses a system for monitoring a physical change in an offshore structure using optical sensors. Non Patent Document 1 discloses an estimation method for stress produced in a ship and an estimation method for fatigue damage of a ship structure. Non Patent Document 2 discloses an estimation method for a wave spectrum based on values measured by sensors attached to the ship.

Citation List

Patent Document

Patent Document 1: JP 2016-166001 A
Patent Document 2 : WO2016/108183 A1.

Non Patent Literature

Non Patent Document 1: Tetsuo Okada, Yasumi Kawamura, Atsushi Kato, Hideyuki Ando, Takeshi Yonezawa, Fumitaka Kimura, Masanobu Toyoda, Akihiko Yamauchi, Toshiro Arima, Masayoshi Oka, Toshiyuki Matsumoto, Hiroaki Kakizaki: Outline of the research project on hull structure health monitoring of 14,000TEU large container ships, Conference proceedings, the Japan Society of Naval Architects and Ocean Engineers, No. 24, 2017. 05, pp. 31-35
Non Patent Document 2: Yuki Yoshihira, Tetsuo Okada, Yasumi Kawamura, Yuki Terada: A study on the estimation method of an ocean wave spectrum using measured hull responses on 14,000TEU large container ships, Conference proceedings, the Japan Society of Naval Architects and Ocean Engineers, No. 24, 2017. 05, pp. 37-42

Summary of Invention

Technical Problem

There has been a demand for an estimation method for estimating a response at a position of a floating structure such as an FPSO, where a sensor measuring a structural response cannot be attached.

The present disclosure provides an estimation device, an estimation method, and a program that can solve the above-described problem.

Solution to Problem

An estimation device according claim 1 includes: a strain response spectrum acquisition unit configured to acquire a strain response spectrum at an installation position at which a strain sensor is installed on a floating structure, the strain response spectrum being calculated based on a measurement value from the strain sensor; a wave spectrum acquisition unit configured to acquire a wave spectrum of a wave at a position where the floating structure is located; an RAO acquisition unit configured to acquire a strain response function (response amplitude operator (RAO)) at the installation position of the strain sensor and a strain response function (RAO) at a non-installation position of the strain sensor, calculated based on a structure model of the floating structure; a correction amount calculation unit configured to calculate, based on the strain response spectrum and the strain response function (RAO) at the installation position of the strain sensor, the wave spectrum, and a formula expressing a relationship among the strain response spectrum and the strain response function (RAO) at the installation position of the strain sensor and the wave spectrum, a correction amount for a difference between a theoretical value of the strain response spectrum at the installation position of the strain sensor calculated from the strain response function (RAO) and the wave spectrum and the strain response spectrum at the installation position of the strain sensor; and a strain response spectrum estimation unit configured to calculate, based on a theoretical value of the strain response spectrum at the non-installation position calculated from the strain response function (RAO) and the wave spectrum at the non-installation position of the strain sensor, and the correction amount, the strain response spectrum at the non-installation position.

An estimation method according to claim 9 includes: a step of acquiring a strain response spectrum at an installation position at which a strain sensor is installed on a floating structure, the strain response spectrum being calculated based on a measurement value from the strain sensor; a step of acquiring a wave spectrum of a wave at a position where the floating structure is located; a step of acquiring a strain response function at the installation position of the strain sensor and a strain response function (RAO) at a non-installation position of the strain sensor, calculated based on a structure model of the floating structure; a step of calculating, based on the strain response spectrum and the strain response function (RAO) at the installation position of the strain sensor, the wave spectrum, and a formula expressing a relationship among the strain response spectrum and the strain response function (RAO) at the installation position of the strain sensor and the wave spectrum, a correction amount for a difference between a theoretical value of the strain response spectrum at the installation position of the strain sensor calculated from the strain response function (RAO) and the wave spectrum and the strain response spectrum at the installation position of the strain sensor; and a step of calculating, based on a theoretical value of the strain response spectrum at the non-installation position calculated from the strain response function (RAO) and the wave spectrum at the non-installation position of the strain sensor, and the correction amount, the strain response spectrum at the non-installation position.

A program according to claim 10 causes a computer to execute processing including: acquiring a strain response spectrum at an installation position at which a strain sensor is installed on a floating structure, the strain response spectrum being calculated based on a measurement value from the strain sensor; acquiring a wave spectrum of a wave at a position where the floating structure is located; acquiring a strain response function (response amplitude operator (RAO)) at the installation position of the strain sensor and a strain response function (RAO) at a non-installation position of the strain sensor, calculated based on a structure model of the floating structure; calculating, based on the strain response spectrum and the strain response function (RAO) at the installation position of the strain sensor, the wave spectrum, and a formula expressing a relationship among the strain response spectrum and the strain response function (RAO) at the installation position of the strain sensor and the wave spectrum, a correction amount for a difference between a theoretical value of the strain response spectrum at the installation position of the strain sensor calculated from the strain response function (RAO) and the wave spectrum and the strain response spectrum at the installation position of the strain sensor; and calculating, based on a theoretical value of the strain response spectrum at the non-installation position calculated from the strain response function (RAO) and the wave spectrum at the non-installation position of the strain sensor, and the correction amount, the strain response spectrum at the non-installation position.

Advantageous Effects of Invention

The estimation device, the estimation method, and the program described above enable estimation of a response at a position where a sensor that detects a structural response is not installed.

Brief Description of Drawings

FIG. 1 is a block diagram illustrating an example of a monitoring device according to an embodiment.
FIG. 2 is a diagram illustrating an example of a floating structure according to an embodiment.
FIG. 3 is a diagram illustrating an example of a structure model of the floating structure according to an embodiment.
FIG. 4A is a diagram illustrating a correction amount according to an embodiment.
FIG. 4B is a diagram illustrating a correction amount S according to an embodiment.
FIG. 5 is a flowchart illustrating an example of estimation processing for a strain response spectrum at an unmeasured position according to an embodiment.
FIG. 6 is a diagram illustrating an example of a Bayesian network model obtained by entirely modeling the strain response spectrum estimation processing at the unmeasured position according to an embodiment.
FIG. 7 is a diagram illustrating an example of a hardware configuration of the monitoring device according to an embodiment.

Description of Embodiments

Embodiments

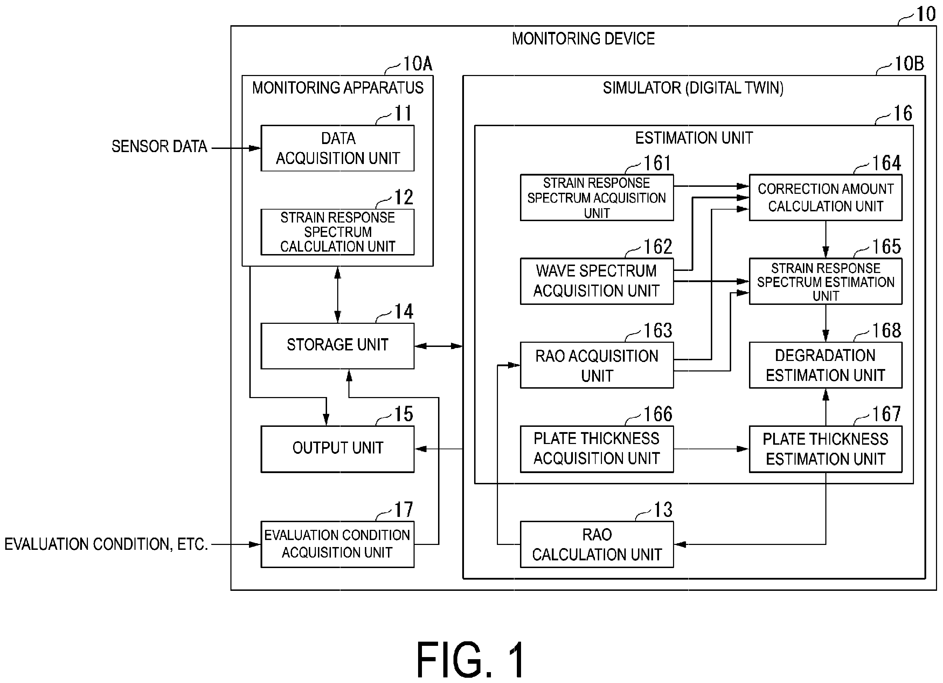

A monitoring device according to the present disclosure will be described below with reference to FIG. 1 to FIG. 7.

Configuration

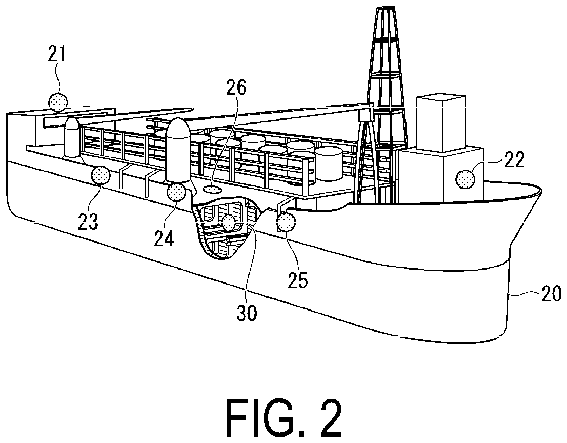

FIG. 1 is a block diagram illustrating an example of a monitoring device according to an embodiment.
A monitoring device 10 monitors the state of an offshore floating structure. Examples of the floating structure include an FPSO, an offshore wind turbine, and the like. The monitoring device 10 includes: a monitoring apparatus 10A that acquires measurement values measured by various sensors attached to the floating structure, calculates a monitoring parameter by performing required calculation or the like on the measurement values, and outputs the monitoring parameter; and a simulator (digital twin) 10B that simulates an operation, an internal state, and the like of the floating structure based on a three-dimensional structure model and the like of the floating structure. The monitoring device 10 includes a data acquisition unit 11, a strain response spectrum calculation unit 12, an RAO calculation unit 13, a storage unit 14, an output unit 15, an estimation unit 16, and an evaluation condition acquisition unit 17. For example, the data acquisition unit 11 and the strain response spectrum calculation unit 12 are functions of the monitoring apparatus 10A. The RAO calculation unit 13 and the estimation unit 16 are functions of the simulator 10B.
The data acquisition unit 11 acquires a strain measured by a strain sensor, an acceleration measured by an accelerometer, a wave spectrum output from a wave radar, a measurement value of a plate thickness measured by a plate thickness sensor, and the like. FIG. 2 illustrates an example of the floating structure. A wave radar 21, an accelerometer 22, strain sensors 23 to 25, and a plate thickness sensor 26 are attached to the floating structure. These sensors and the monitoring device 10 are communicatively connected to each other. Each of the sensors performs measurement for a measurement target at a predetermined control interval, and transmits a result of the measurement to the monitoring device 10. The data acquisition unit 11 acquires the wave spectrum output from the wave radar 21, as well as sensor data measured by the accelerometer 22, the strain sensors 23 to 25, and the plate thickness sensor 26 and writes and stores each piece of the sensor data in the storage unit 14 together with the measurement time. The wave spectrum indicates the power of the wave with each frequency and wave direction. The plate thickness sensor 26 measures the plate thickness of a structure of the floating structure (the upper deck of the floating structure, for example), and inputs the result of the measurement to the monitoring device 10. The data acquisition unit 11 further acquires the plate thickness of an internal structure such as a tank inner surface measured in a regular inspection, and writes and stores the plate thickness in the storage unit 14 together with the measurement date. When a crack is found during the inspection, the position and the length of the crack are written and stored in the storage unit 14 together with the measurement date. A position 30 illustrated in FIG. 2 is an example of an evaluation target position on which the strain sensor cannot be attached, such as a tank inner surface structure member.
The strain response spectrum calculation unit 12 reads time history data on the strain measured by the strain sensors 23 to 25 from the storage unit 14, and calculates a strain response spectrum at the positions where the strain sensors 23 to 25 are installed. The method for calculating the strain response spectrum is known, and thus is not described in the present specification. The strain response spectrum indicates the strain (or stress) spectrum for each frequency. The strain response spectrum calculation unit 12 writes and stores the calculated strain response spectrum in the storage unit 14. The strain and the stress are values that are easily interchangeable using a material constant, and thus can be treated as the same meaning. In many cases, the strain and the stress are respectively used in measurement and calculation. In the present specification, for example, a description will be given using the strain as an example, that is, using a strain response spectrum and a strain response function that can be respectively replaced with a stress response spectrum and a stress response function.

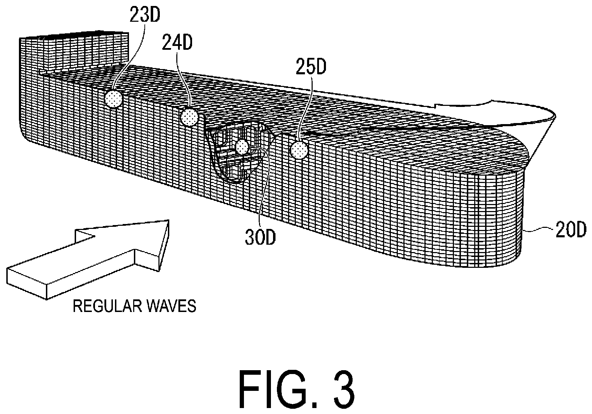

The RAO calculation unit 13 calculates a strain response function (response amplitude operator (RAO)), through a finite element method (FEM) analysis using a structure model of the floating structure or any other like structure analysis. FIG. 3 illustrates an example of a three-dimensional structure model. A structure model 20D is a three-dimensional model simulating a structural response of a floating structure 20. The RAO calculation unit 13 uses the structure model 20D to perform semi-static FEM analysis for a case where the floating structure receives regular waves, and calculates the strain response function (RAO) at positions 23D to 25D corresponding to the positions where the strain sensors 23 to 25 are attached, and a position 30D corresponding to an evaluation target position 30. The RAO calculation unit 13 performs the FEM analysis using the latest information on the plate thickness stored in the storage unit 14. The strain response function (RAO) is a set of strain response magnifications corresponding to a ratio between the length of the ship and the wavelength of waves, for each wave direction. In other words, the strain response function (RAO) is a set of strain response magnifications for each frequency of waves in each wave direction. For example, with the strain response function (RAO), a large strain response magnification is obtained with a wave having a frequency matching the natural frequency of a structure. The method for calculating the strain response function (RAO) is known, and thus, not described in the present specification. The RAO calculation unit 13 calculates the strain response functions (RAO) for regular waves of various frequencies from various directions, and writes and stores the strain response functions (RAO) in the storage unit 14 in advance. Hereinafter, the positions where the strain sensors 23 to 25 are attached may be referred to as positions 23 to 25 or measured points 23 and 25. Similarly, the position where the plate thickness sensor 26 is attached may be described as a position 26 or a measured point 26.

When latest plate thickness information measured by the plate thickness sensor 26 is obtained, a plate thickness estimation unit 167 estimates plate thicknesses at the positions 23 to 25 and 30 while taking into consideration the thinning due to corrosion. Then, the RAO calculation unit 13 recalculates the strain response functions (RAO) at the positions 23 to 25 and 30 using the plate thickness estimated values at the positions 23 to 25 and 30, taking into consideration the increase in stress due to the reduction of the plate thickness.

The storage unit 14 stores the sensor data acquired by the data acquisition unit 11, the structure model 20D of the digital twin, and the calculation results such as the strain response spectrum and the strain response functions (RAO).

The output unit 15 outputs the strain response spectrum at a position where the strain sensor is not installed, or the like, to a monitor or an electronic file.

The estimation unit 16 estimates the strain response spectrum at a strain sensor non-installation position (position 30), based on the wave spectrum acquired by the data acquisition unit 11, the strain response spectrum at the strain sensor installation positions (positions 23 to 25) calculated by the strain response spectrum calculation unit 12, and the strain response function (RAO) at the strain sensor installation position and the strain response function (RAO) at the non-installation position calculated by the RAO calculation unit 13. The estimation unit 16 corrects the strain response spectrum described above successively, based on the strain response function (RAO) recalculated by the RAO calculation unit 13, using an estimated value of the plate thickness estimated by the plate thickness estimation unit 167 while taking into consideration the thinning due to corrosion at the plate thickness sensor unmeasured position (positions 23 to 25 and 30). The estimation unit 16 estimates the fatigue level/remaining service life at the strain sensor non-installation position. Thus, it is possible to figure out the strain response spectrum and the fatigue level/remaining service life at a position where the strain sensor cannot be attached. The estimation method for the fatigue level/remaining service life based on the strain response spectrum is known and thus the description thereof will be omitted.

The estimation unit 16 includes a strain response spectrum acquisition unit 161, a wave spectrum acquisition unit 162, an RAO acquisition unit 163, a correction amount calculation unit 164, a strain response spectrum estimation unit 165, a plate thickness acquisition unit 166, the plate thickness estimation unit 167, and a degradation estimation unit 168.

The strain response spectrum acquisition unit 161 reads and thus acquires the strain response spectrum at the positions 23 to 25 in FIG. 2 from the storage unit 14. The strain response spectrum acquisition unit 161 outputs the strain response spectrum to the correction amount calculation unit 164.

The wave spectrum acquisition unit 162 reads and thus acquires the wave spectrum from the storage unit 14. The wave spectrum acquisition unit 162 outputs the wave spectrum to the correction amount calculation unit 164 and the strain response spectrum estimation unit 165.

The RAO acquisition unit 163 reads and thus acquires RAO information (strain response magnification for each frequency) corresponding to the same wave direction as the wave direction of the wave spectrum measurement result, from the storage unit 14 storing information calculated by the RAO calculation unit 13 for the strain response function (RAO) at the positions 23D to 25D and 30D in FIG. 3. The RAO acquisition unit 163 outputs the RAO information to the correction amount calculation unit 164 and the strain response spectrum estimation unit 165.

The correction amount calculation unit 164 calculates a correction amount for the strain response spectrum at the position 30D. In general, it is known that the strain response spectrum, the strain response function (RAO), and the wave spectrum satisfy the relationship expressed by the following Formula (1):

Strain response spectrum = (strain response function (RAO))$^2$ × wave spectrum          (1).

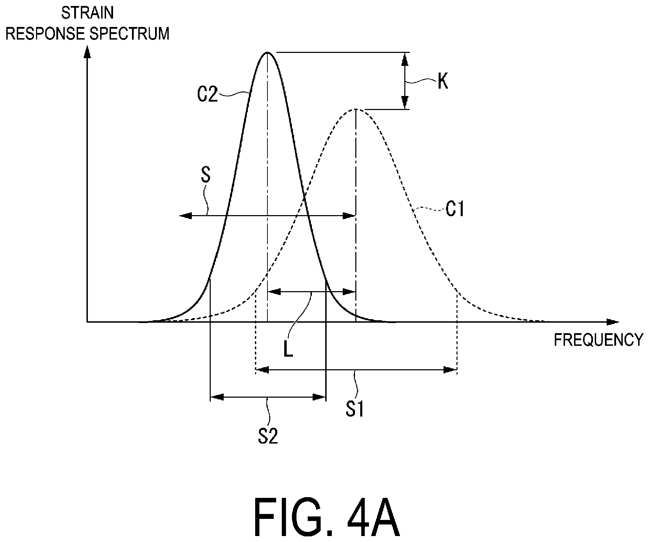

The correction amount calculation unit 164 calculates the correction amount for correcting the difference between the left side and the right side in Formula (1), from the strain response spectrum based on the measurement values at the positions 23 to 25, the strain response function (RAO) calculated for the positions 23D to 25D, the wave spectrum, and the relationship expressed by Formula (1). Reference is now made to FIG. 4A.

FIG. 4A is a diagram illustrating a correction amount according to the embodiment.

The vertical axis and the horizontal axis of a graph in FIG. 4A respectively represent the strain response spectrum and the frequency. A curve C1 indicates the strain response spectrum based on the measurement value at any of the positions 23 to 25. Thus, the curve C1 corresponds to the left side in Formula (1) at any of the positions 23 to 25. A curve C2 is a waveform obtained by multiplying the square of the strain response function (RAO) calculated for the position corresponding to the curve C1 among the positions 23D to 25D, by the wave spectrum. Thus, the curve C2 corresponds to the right side in Formula (1). The strain response spectrum, the strain response function (RAO), and the wave spectrum at the strain measured points 23 to 25 are known through measurement and analysis. Thus, a difference obtained through comparison between the right side and the left side in Formula (1) is defined as an error in the strain response function (RAO). Thus, the error between the right side and the left side in Formula (1) is regarded as an error between the structure model 20D and the current floating structure 20. With the error thus defined, by obtaining the correction amount for correcting the error, a difference between the structural response of the floating structure calculated by the structure model 20D established under the design condition and the response of the current floating structure 20 can be compensated. For a position where the sensor detecting the response of the structure is not installed, the response can be estimated with high accuracy at the position where the sensor is not installed by using the response value and the correction amount calculated by the method of the present embodiment. Specifically, the strain response spectrum at the strain sensor non-installation position 30 can be estimated.

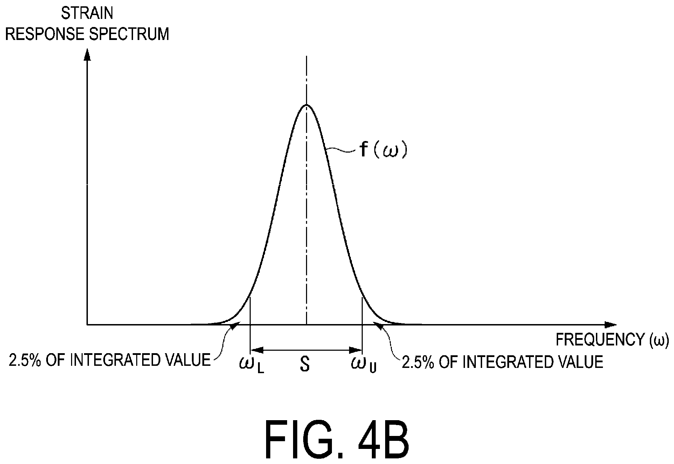

An example of the definition is described using errors L, K, and S in FIG. 4A. The right side and the left side in Formula (1) described above may not match. Since the comparison is made between distributions, there are three possible differences therebetween including an error L in the peak position, an error K in the peak amount, and an error S related to a distribution width between the curve C1 and the curve C2 as illustrated in the graph in FIG. 4A. The error K is a difference between the maximum value of the strain response spectrum of the curve C1 and the maximum value of the strain response spectrum of the curve C2. The error L is a difference between the position on the horizontal axis where the strain response spectrum of the curve C1 has the maximum value, and the position on the horizontal axis where the strain response spectrum of the curve C2 has the maximum value. For the error S, first, consideration is given to an integrated value m of a frequency domain of the strain response spectrum $f(\omega)$ illustrated in FIG. 4B. Specifically, m is defined by the following Formula (2). Then, for predetermined $\alpha$ ($\alpha$ = 5% in FIG. 4B), a lower limit value and an upper limit value of an interval of both side sections 100 × (1 - $\alpha$)% of m are respectively defined by $\omega_L$ in Formula (3) and $\omega_U$ in Formula (4).

[Math. 1]

$$m = \int_0^\infty f(\omega)d\omega \qquad \cdots (2)$$

[Math. 2]

$$\int_0^{\omega_L} f(\omega)d\omega = m\frac{\alpha}{2}\% \qquad \cdots (3)$$

[Math. 3]

$$\int_{\omega_U}^\infty f(\omega)d\omega = m\frac{\alpha}{2}\% \qquad \cdots (4)$$

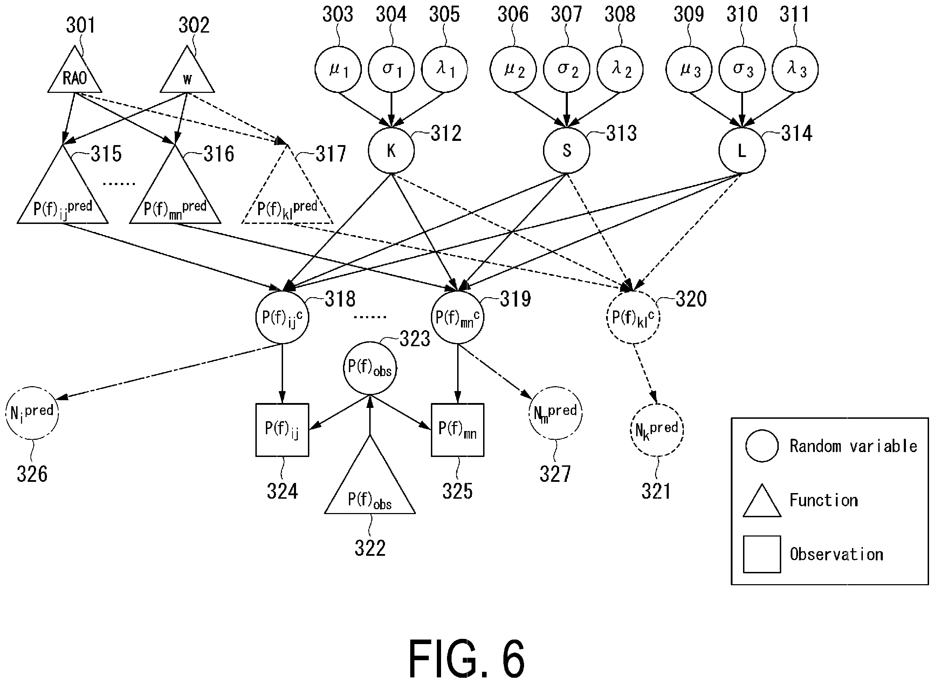

Next, the length of the interval of both side sections $100 \times (1 - \alpha)\%$ is defined by a difference $S = \omega_U - \omega_L$ between the upper limit value $\omega_U$ and the lower limit value $\omega_L$. Then, using this length S of the two-sided interval, the error S related to the distribution width is defined as follows. Specifically, the error S in the example illustrated in FIG. 4A is the value calculated by S1/S2, where S1 is a length of a two-sided 95% interval ($\alpha$ = 5%; 95% is an example, and for example, the value may be 99% ($\alpha$ = 1%) or 90% ($\alpha$ = 10%)) of the integrated value of the frequency domain of the strain response spectrum of the curve C1, and S2 is a length of a two-sided 95% interval of the integrated value of the frequency domain of the strain response spectrum of the curve C2. The correction amount calculation unit 164 calculates the error L, the error K, and the error S as correction amounts. In the following description, a correction amount for correcting the error L may be referred to as a correction amount L, a correction amount for correcting the error K may be referred to as a correction amount K, and a correction amount for correcting the error S may be referred to as a correction amount S. While a correction amount calculation method for estimating the response at the unmeasured position taking into consideration uncertainties will be described below with reference to FIG. 6, as an extremely simple method, the correction amount calculation unit 164 may calculate the error L, the error K, and the error S using Formula (1) for each of the positions 23 to 25, and obtain an average value of each type of error as the correction amount. Alternatively, based on the positional relationship with the evaluation target position 30, the correction amount calculation unit 164 may use the correction amount calculated for the closest position. For example, when the evaluation target position 30 is located between the position 24 and the position 25, the correction amount calculation unit 164 obtains the average values of the errors L, the errors K, and the errors S calculated for the positions 24 and 25, as the correction amount L, the correction amount K, and the correction amount S for the evaluation target position 30.

As described below, the correction amount calculation unit 164 may calculate the correction amount L, the correction amount K, and the correction amount S for each position and for each wave condition, and may calculate the correction amount L, the correction amount K, and the correction amount S corresponding to the property of the member at the position, in addition to the position and the wave condition.

The strain response spectrum estimation unit 165 calculates a theoretical value of the strain response spectrum at the evaluation target position 30 using the right side in Formula (1), and corrects the theoretical value using the correction amounts (the correction amount L, the correction amount K, and the correction amount S) calculated by the correction amount calculation unit 164, to calculate the estimated value of the strain response spectrum. Specifically, the strain response spectrum estimation unit 165 multiplies the wave spectrum acquired by the wave spectrum acquisition unit 162 by the square of the strain response function (RAO) at the position 30D acquired by the RAO acquisition unit 163. Then, for the resultant distribution curve (curve C2 in FIG. 4A), the position of the peak value is corrected by adding or subtracting the correction amount L to or from the position of the maximum value of the strain response spectrum, the peak value is corrected by adding or subtracting the correction amount K to or from the maximum value, and the distribution width is corrected through multiplication of the width of a 95% confidence interval by the correction amount S or the like. The strain response spectrum estimation unit 165 outputs the strain response spectrum thus estimated to the degradation estimation unit 168.

The plate thickness acquisition unit 166 reads and thus acquires the information on the plate thickness of the floating structure 20 measured by the plate thickness sensor 26 from the storage unit 14. The plate thickness sensor 26 is attached to a position of the floating structure 20 where the sensor can be easily installed, such as the upper deck. The plate thickness sensor 26 constantly measures the plate thickness of the upper deck and transmits the latest measurement result to the monitoring device 10.

The plate thickness estimation unit 167 estimates the plate thicknesses at the strain sensor installation position and the strain sensor non-installation position, by using an estimation formula estimated from a theoretical solution or actual measurement or the like, based on the information on the plate thickness acquired from the plate thickness acquisition unit 166 and a result of inspecting the plate thickness. For example, the plate thickness estimation unit 167 stores a table (theoretical solution) and a function (actual measurement empirical formula) indicating the association between the thinning amount at the installation position (the upper deck for example) of the plate thickness sensor 26 and the thinning amount at the plate thickness estimation target position. The table and the function define, for example, a relationship such as a thinning of 1 mm at the upper deck leads to a thinning of 0.5 mm at the position 25 and a thinning of 0.3 mm at the position 30. The table and the like are prepared in advance from results of measurements or experiments on an actual ship, theoretical calculation, or the like. The plate thickness estimation unit 167 estimates the thinning amount at the estimation target position based on the latest plate thickness of the upper deck or the like measured by the plate thickness sensor 26 and the table or the like indicating the association described above, and estimates the plate thickness of the estimation target position based on the estimated value of the thinning amount. When the plate thicknesses at the positions 23 to 25 are measured by a regular inspection or the like for example, the error between the actual plate thickness and the plate thickness estimated value estimated using the table or the like described above can be calculated. The plate thickness estimation unit 167 may store the error thus calculated as the correction amount, and add the correction amount based on the inspection result to the estimated value of the plate thickness estimated based on the table or the like described above, to estimate the plate thickness at the estimation target position. Alternatively, the plate thickness estimation unit 167 may estimate the plate thickness at the estimation target position by the Bayes method based on the measurement result from the plate thickness sensor 26 and the measurement result of the plate thickness measured by a regular inspection or the like. The plate thickness estimation unit 167 outputs estimated values of the plate thicknesses of the sensor installation position and the sensor non-installation position to the RAO calculation unit 13 and to the degradation estimation unit 168. Based on the latest plate thickness measurement value, the RAO calculation unit 13 calculates the latest strain response function (RAO) at the strain sensor installation position (positions 23D to 25D) estimated, and the latest strain response function (RAO) at the strain sensor non-installation position (position 30D). The correction amount calculation unit 164 calculates the correction amounts K, S, and L using these latest strain response functions (RAO). The strain response spectrum estimation unit 165 estimates the strain response spectrum by using the latest strain response function (RAO).

When the plate thickness changes, the strain response spectrum of the structure also changes. In the present embodiment, by updating the strain response function (RAO) and the correction amount based on the latest plate thickness estimated value, the strain response spectrum at the strain sensor non-installation position can be estimated with high accuracy.

The degradation estimation unit 168 uses a known method using an SN diagram (fatigue diagram) to estimate the fatigue level/remaining service life of the floating structure. Based on the estimated value of the plate thickness at the strain sensor non-installation position, or a joint type of the structure at the strain sensor non-installation position, the degradation estimation unit 168 selects an SN diagram based on joint classification including the plate thickness or an SN diagram based on a hotspot stress using the plate thickness as a parameter. Furthermore, the SN diagram is selected while taking into consideration the corrosion environment, so that the service life can be estimated with high accuracy. The degradation estimation unit 168 estimates the current short-term fatigue level of floating structure, based on the SN diagram selected and the strain response spectrum obtained. The degradation estimation unit 168 estimates the future fatigue level of the floating structure, based on the SN diagram selected and a distribution of the number of times of occurrence of stress in a long term. When a crack is found in a regular inspection, the degradation estimation unit 168 can similarly estimate how the crack will grow in the future through a known method, and estimate when the crack will become a dangerous length.

The evaluation condition acquisition unit 17 acquires evaluation target data and an evaluation condition for the strain response spectrum estimation. Examples of the evaluation condition include the location of the evaluation target position, a wave condition (frequency and wave direction), and the like.

Operation

Next, estimation processing for a strain response spectrum at an unmeasured point will be described.

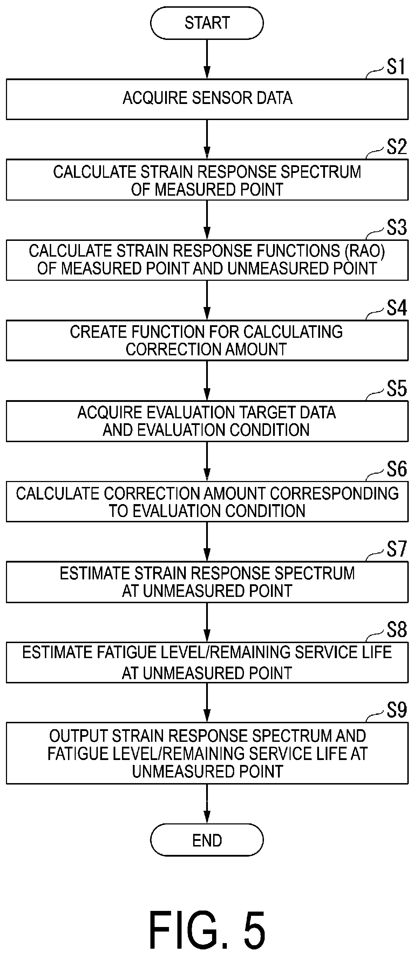

FIG. 5 is a flowchart illustrating an example of the estimation processing for a strain response spectrum at an unmeasured position according to the embodiment. With processes in step S1 to S4, the function for outputting the correction amount for each position and each wave condition is prepared. With processes in step S5 to S8, the strain response spectrum and the remaining service life at the sensor non-installation position are calculated.

Preparation of Function for Outputting Correction Amount

First, the data acquisition unit 11 acquires sensor data measured within a predetermined period (step S1). The data acquisition unit 11 acquires a wave spectrum, strain, acceleration, and plate thickness measured within the predetermined period of time.

Next, the strain response spectrum calculation unit 12 calculates the strain response spectrum using a known method based on the measurement values measured by the strain sensor during a certain period of time (step S2).

Next, the RAO calculation unit 13 uses the structure model 20D to calculate the strain response function (RAO) at the measured point that is a sensor installation position and the strain response function (RAO) at the unmeasured point (step S3). The calculation is performed under a regular wave load condition under any wave condition (frequency and wave direction). The strain response function (RAO) is assumed to be calculated based on information on the latest plate thickness estimated by the plate thickness estimation unit 167.

Next, the correction amount calculation unit 164 prepares a function for calculating the correction amount L, the correction amount K, and the correction amount S for each position and for each wave condition, based on the concept described with reference to FIG. 4A and FIG. 4B (step S4). Examples of the wave condition include the frequency of the wave and the wave direction. For example, upon receiving the position information and wave condition of the position 23, the correction amount calculation unit 164 prepares the function for outputting the correction amount L, the correction amount K, and the correction amount S for the position 23 satisfying the wave condition. A method of preparing the function for calculating the correction amount for each position and for each wave condition will be described below with reference to FIG. 6. The correction amount calculation unit 164 prepares each of the function for outputting the correction amount L, the function for outputting the correction amount S, and the function for outputting the correction amount K, and writes and stores the functions in the storage unit 14. The correction amount calculation unit 164 may prepare a function for calculating a correction amount for a property of each member such as a general plate structure, a bone structure, and an intersection between bones. For example, when the member at the position 23 has a property A, the member at the position 24 has a property B, and the member at the position 25 has the property A, the correction amount calculation unit 164 prepares the function corresponding to the property A for the position 23 and the position 25, and prepares the function corresponding to the property B for the position 24.

Estimation of Response and Remaining Service Life at Sensor Non-installation Position

Next, the evaluation condition acquisition unit 17 acquires the evaluation target data and the evaluation condition (step S5). For example, the evaluation condition acquisition unit 17 acquires the strain response function (RAO) of the evaluation target position 30D and a wave spectrum measured within a certain period of time, as the evaluation target data. The evaluation condition acquisition unit 17 acquires the wave condition (wave direction and frequency) corresponding to the evaluation target position 30 and the wave spectrum of the evaluation target data, as the evaluation condition. The evaluation target data may be the data obtained in step S1, or may be newly acquired data. When the wave spectrum fails to be measured for some reason, the wave spectrum may be estimated through an existing calculation formula using the significant wave height, wave direction, wave period, and the like of the target sea area obtained in a different way.

Next, the correction amount calculation unit 164 calculates the correction amount corresponding to the evaluation condition (step S6). The correction amount calculation unit 164 inputs the evaluation target position and the wave condition designated by the evaluation condition to the function for the correction amount K to acquire the correction amount K corresponding to the evaluation condition. Similarly, the correction amount calculation unit 164 inputs the evaluation condition to the function for the correction amount S to acquire the correction amount S, and inputs the evaluation condition to the function for the correction amount L to acquire the correction amount L. For example, when the member at the position 30 has the property B, the correction amount calculation unit 164 inputs the evaluation condition to the respective functions for the correction amounts K, S, and L prepared for the property B, to acquire the correction amounts K, S, and L corresponding the property B, the position, and the wave condition.

Next, the strain response spectrum estimation unit 165 estimates the strain response spectrum at the unmeasured point (step S7). The strain response spectrum estimation unit 165 calculates the strain response spectrum at the evaluation target position 30, by correcting, using the correction amounts calculated at step S6, a value obtained by multiplying the square of the strain response function (RAO) calculated for the evaluation target position 30D by the wave spectrum of the evaluation target data.

Next, the degradation estimation unit 168 estimates the fatigue level/remaining service life at the unmeasured point (step S8). The degradation estimation unit 168 estimates the fatigue level/remaining service life of the structure at the unmeasured point, based on the strain response spectrum estimated by the strain response spectrum estimation unit 165 and the SN diagram based on the joint type including the latest plate thickness or the SN diagram based on hotspot stress using the plate thickness as a parameter. Next, the output unit 15 outputs the strain response spectrum at the evaluation target position 30 and the fatigue level/remaining service life of the structure at the evaluation target position 30 to a display or an electronic file (step S9). Thus, the strain response spectrum and the fatigue level/remaining service life at the sensor non-installation position can be figured out.

Details of Calculation for Correction Amount

Next, an example of a correction amount calculation method will be described with reference to FIG. 6.

FIG. 6 illustrates an example of an estimation model obtained by entirely modeling, with a Bayesian network, the strain response spectrum estimation processing at the unmeasured position according to the embodiment.

The correction amount calculation unit 164 creates the estimation model illustrated as an example in FIG. 6.

In the estimation model of FIG. 6, the correction amount K is expressed by a Gaussian process regression model using parameters $\mu 1$, $\sigma 1$, and $\lambda 1$. These K, $\mu 1$, $\sigma 1$, and $\lambda 1$ respectively correspond to variables 312, 303, 304, and 305 in FIG. 6. Similarly, the correction amount S is expressed by a Gaussian process regression model using parameters $\mu 2$, $\alpha 2$, and $\lambda 2$, and the correction amount L is expressed by a Gaussian process regression model using parameters $\mu 3$, $\alpha 3$, and $\lambda 3$. These S, $\mu 2$, $\alpha 2$, and $\lambda 2$ respectively correspond to variables 313, 306, 307, and 308 in FIG. 6, and these L, $\mu 3$, $\alpha 3$, and $\lambda 3$ respectively correspond to variables 314, 309, 310, and 311 in FIG. 6. The Gaussian process regression models of the correction amount K, S, L are functions of position and wave condition. For example, when the position and the wave condition are input to a function $f_k$ expressed by the Gaussian process regression model for the correction amount K, the Gaussian process regression model calculates the correction amount K corresponding to the position and the wave condition. The same applies to the correction amounts S and L.

In the model illustrated in FIG. 6, an arrow indicates that an object pointed by the arrow depends on an object from which the arrow extends. For example, the correction amount K depends on the parameters $\mu1$, $\sigma1$, and $\lambda1$. Based on the model illustrated in FIG. 6, the correction amount calculation unit 164 performs regression analysis, using a method such as the Gaussian process regression, on a relationship between the strain response spectrum based on the measurement value obtained by the strain sensor and a value obtained by correcting the theoretical value of the strain response spectrum using the correction amount K expressed by $\mu1$, $\sigma1$, and $\lambda1$, the correction amount S expressed by $\mu2$, $\alpha2$, and $\lambda2$, and the correction amount L expressed by $\mu3$, $\alpha3$, and $\lambda3$ and adjusts the values of the parameters $\mu1$ to $\mu3$, $\sigma1$ to $\sigma3$, and $\lambda1$ to $\lambda3$, to obtain a function $f_k$ for the correction amount K, a function $f_S$ for the correction amount S, and a function $f_L$ for the correction amount L for calculating the correction amounts K, S, and L with high accuracy. When the Gaussian process regression is used, with an estimation method taking into consideration a correlation between input variables (position and wave condition), a tendency that a similar input leads to a similar output can be evaluated.

A function 301 outputs a strain response function (RAO) corresponding to the position and wave condition, and a function 302 outputs a wave spectrum corresponding to the wave condition. A function 315 is for calculating and outputting the theoretical value of the strain response spectrum (the right side in Formula (1)) at a position i and under a wave condition j, from the strain response function (RAO) output from the function 301 and the wave spectrum output from the function 302. Similarly, a function 316 is for calculating the theoretical value of the strain response spectrum at a position m and under a wave condition n, and a function 317 is for calculating the theoretical value of the strain response spectrum at a position k and under a wave condition 1. The position i and the position m are positions where the strain sensors are installed, and the position 1 corresponds to a non-installation position. A variable 318 is a value obtained by correcting the theoretical value of the strain response spectrum output by the function 315 using the correction amounts K, S, and L. Similarly, a variable 319 is the corrected strain response spectrum at the position m and under the wave condition n. A variable 320 is the corrected strain response spectrum at the position k and under the wave condition 1. On the other hand, a function 322 is a function that outputs a true value of the strain response spectrum. The function 322 outputs a variable 323 that is a true value of the strain response spectrum. An observed value 324 is a value actually observed at the position i and under the wave condition j. An observed value 325 is a value actually observed at the position k and under the wave condition 1. The observed values 324 and 325 correspond to values calculated by the strain response spectrum calculation unit 12 from the measurement values obtained by the strain sensors. The observed values 324 and 325 are values including a measurement error. As illustrated in the figure, the observed value 324 depends on the variable 318 and the variable 323, and the observed value 325 depends on the variable 319 and the variable 323. The remaining service life (variable 326) at the position i is estimated based on the corrected strain response spectrum (variable 318) at the position i. The same applies to the remaining service life (variable 327) at the position m and the remaining service life (variable 321) at the position k. The correction amount calculation unit 164 calculates the parameters $\mu1$ to $\mu3$, $\sigma1$ to $\sigma3$, and $\lambda1$ to $\lambda3$ resulting in a small error between the variable 318 and the observed value 324 and a small error between the variable 319 and the observed value 325, based on the estimation model illustrated as an example in FIG. 6. For example, the correction amount calculation unit 164 acquires a large number of sets of strain response spectra, wave spectra, and strain response functions (RAO), based on measurement values measured at the positions i to m and under the wave conditions j to n, and calculates the parameters $\mu1$ to $\mu3$, $\sigma1$ to $\sigma3$, and $\lambda1$ to $\lambda3$ resulting in a small difference between the strain response spectrum (observed values 324 and 325) based on the measurement values and the corrected strain response spectrum (variables 318 and 319), through regression analysis such as the Gaussian process regression. When the parameters $\mu1$ to $\mu3$, $\sigma1$ to $\sigma3$, and $\lambda1$ to $\lambda3$ are calculated, the function $f_K$ for the correction amount K using the parameters $\mu1$, $\sigma1$, and $\lambda1$, the function $f_S$ for the correction amount S using the parameters $\mu2$, $\sigma2$, and $\lambda2$, and the function $f_L$ for the correction amount L using the parameters $\mu3$, $\sigma3$, and $\lambda3$ are obtained. These functions $f_K$, $f_S$, and $f_L$ are functions of position and wave condition. Thus, the functions for the correction amounts K, S, and L with high accuracy can be calculated.

In the example illustrated in FIG. 6, the correction amount calculation unit 164 calculates the functions that output the correction amounts K, S, and L based on the position and the wave condition. Alternatively, the correction amount calculation unit 164 may prepare a Bayesian network model for each property of a member at each sensor installation position, and calculate functions that output the correction amounts K, S, and L corresponding to the position and the wave condition for each member property.

The correction amounts K, S, and L are not limited to the Gaussian process regression, and may be other regression analysis methods such as polynomial regression, polynomial chaos expansion, or neural net regression. By calculating the regression parameters of these regression analysis methods, the strain response spectrum at the strain sensor non-installation position can be estimated with high accuracy.

Through the method of preparing the estimation model illustrated as an example in FIG. 6 and preparing the functions for the correction amounts K, S, and L through regression analysis, actual measurement data can be accumulated and the correction amounts K, S, and L can be updated as appropriate through recalculation. Through the data update using monitoring data, the stress can be estimated with high accuracy, with uncertainty further reduced.

The processing of preparing the functions (functions of position and wave condition) for the correction amounts K, S, and L with this method will be described with reference to the flowchart in FIG. 5. In step S4, the correction amount calculation unit 164 prepares the respective functions for the correction amounts K, S, and L. In step S6, the position and the wave condition set in step S5 are input to each of the functions for the correction amounts K, S, and L. As a result, the correction amounts K, S, and L appropriate for the position and the wave condition are calculated, and the correction amounts are output to the strain response spectrum estimation unit 165. The other steps are similar to those described above.

Recently, a digital twin has been increasingly used for hull monitoring. In this context, there is room for improvement in terms of organic cooperation between measured values and a simulation result obtained by the digital twin. With the present embodiment, a physical quantity (the strain response spectrum and the remaining service life based on the strain response spectrum) can be estimated with high accuracy, for a portion not measured by the strain sensors, through data synchronization between the monitoring result and the simulation result. In particular, in a floating structure such as an FPSO the inspection and repairing for which are limited, strain is difficult to measure, and it is important to check the fatigue level, the corrosion amount, the remaining service life, and the like for a member in a tank with a high corrosion risk. With the present embodiment, the strain response spectrum in such a portion can be estimated with high accuracy. Thus, the current fatigue level and corrosion amount can be estimated with high accuracy, and the future remaining service life can be predicted while taking the corrosion into consideration, to contribute to inspection planning.

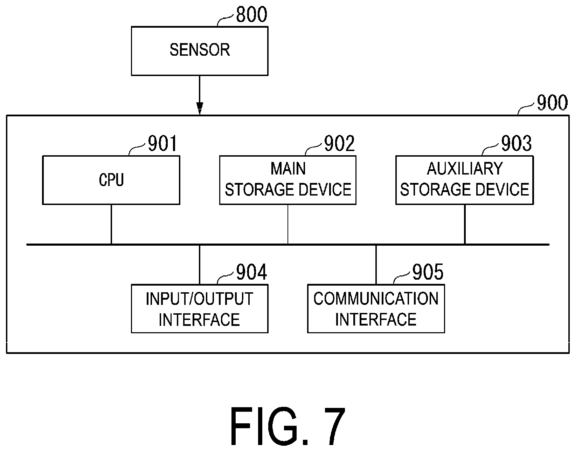

FIG. 7 is a diagram illustrating an example of a hardware configuration of the monitoring device according to the embodiment.

A computer 900 includes a CPU 901, a main storage device 902, an auxiliary storage device 903, an input/output interface 904, and a communication interface 905, and is connected to a sensor 800.

The above-described monitoring device 10 is implemented in the computer 900. The functions described above are stored in the auxiliary storage device 903 in the form of a program. The CPU 901 reads the program from the auxiliary storage device 903, deploys the program to the main storage device 902, and executes the above-mentioned processing in accordance with the program. The CPU 901 secures a storage area in the main storage device 902 in compliance with the program. The CPU 901 secures a storage area for storing data under processing in the auxiliary storage device 903 in compliance with the program. The measurement value measured by the sensor 800 is input to the computer 900 through the input/output interface 904 or the communication interface 905, and is processed by the CPU 901 to be stored in the auxiliary storage device 903.

Note that a program for implementing the whole or part of functions of the monitoring device 10 may be recorded in a computer readable recording medium, and a computer system may be caused to read and execute the program that is recorded in the recording medium to execute the processing of respective functional units. The "computer system" here includes hardware such as an operating system (OS) and peripheral equipment. If a world wide web (WWW) system is used, the "computer system" also includes a home page provision environment (or a display environment). The "computer readable recording medium" refers to a portable medium such as a CD, a DVD, or a USB, or a storage device such as a hard disk built in a computer system. When this program is distributed to the computer 900 through a communication line, the computer 900 receiving the distribution may deploy the program to the main storage device 902, and may execute the above-mentioned processing. The above-described program may implement part of the functions described above, and furthermore, also implement the functions described above in combination with a program already recorded in the computer system.

In the foregoing, certain embodiments of the present disclosure have been described, but all of these embodiments are merely illustrative and are not intended to limit the scope of the invention.

For example, the strain sensors may be stress sensors. A stress response spectrum and a stress response function (RAO) may be used instead of the strain response spectrum and the strain response function (RAO) of the example described above. In this case, for example, Formula (1) above is replaced with the following Formula (1'):

Stress response spectrum = (stress response function (RAO))$^2$ × wave spectrum $\qquad$ (1').

Notes

The estimation device, the estimation method, and the program described in the embodiments can be understood as follows, for example.

(1) An estimation device (monitoring device 10) according to a first aspect includes: a strain response spectrum acquisition unit 161 configured to acquire a strain response spectrum at an installation position at which a strain sensor (sensors 23 to 25) is installed on a floating structure (floating structure 20), the strain response spectrum being calculated based on a measurement value from the strain sensor; a wave spectrum acquisition unit 162 configured to acquire a wave spectrum of a wave at a position where the floating structure is located; an RAO acquisition unit 163 configured to acquire a strain response function (response amplitude operator (RAO)) at the installation position of the strain sensor and a strain response function (RAO) at a non-installation position of the strain sensor, calculated based on a structure model of the floating structure; a correction amount calculation unit 164 configured to calculate, based on the strain response spectrum and the strain response function (RAO) at the installation position of the strain sensor, the wave spectrum, and a formula (Formula (1)) expressing a relationship among the strain response spectrum and the strain response function (RAO) at the installation position of the strain sensor and the wave spectrum, a correction amount (L, K, S) for a difference between a theoretical value of the strain response spectrum at the installation position of the strain sensor calculated from the strain response function (RAO) and the wave spectrum and the strain response spectrum at the installation position of the strain sensor; and a strain response spectrum estimation unit 165 configured to calculate, based on a theoretical value of the strain response spectrum at the non-installation position calculated from the strain response function (RAO) and the wave spectrum at the non-installation position of the strain sensor, and the correction amount, the strain response spectrum at the non-installation position.

With this configuration, the strain response spectrum of a position where the strain sensor is difficult to attach can be estimated. The strain response spectrum at the non-installation position of the strain sensor calculated using a structure model is corrected using the correction amount calculated through data synchronization between a monitoring result and a simulation result. Thus, the strain response spectrum at the non-installation position of the strain sensor can be estimated with high accuracy.

As described above, since strain and stress are interchangeable, the first aspect described above is synonymous with the following description. That is, "an estimation device (monitoring device 10) includes: a strain response spectrum acquisition unit 161 configured to acquire a stress response spectrum at an installation position at which a strain sensor (strain sensors 23 to 25) is installed on a floating structure (floating structure 20), the strain response spectrum being calculated based on a measurement value from the strain sensor; a wave spectrum acquisition unit 162 configured to acquire a wave spectrum of a wave at a position where the floating structure is located; an RAO acquisition unit 163 configured to acquire a stress response function (response amplitude operator (RAO)) at the installation position of the strain sensor and a stress response function (RAO) at a non-installation position of the strain sensor, calculated based on a structure model of the floating structure; a correction amount calculation unit 164 configured to calculate, based on the stress response spectrum and the stress response function (RAO) at the installation position of the strain sensor, the wave spectrum, and a formula (Formula (1)) expressing a relationship among the stress response spectrum and the stress response function (RAO) at the installation position of the strain sensor and the wave spectrum, a correction amount (L, K, S) for a difference between a theoretical value of the stress response spectrum at the installation position of the strain sensor calculated from the stress response function (RAO) and the wave spectrum and the stress response spectrum at the installation position of the strain sensor; and a strain response spectrum estimation unit 165 configured to calculate, based on a theoretical value of the stress response spectrum at the non-installation position calculated from the stress response function (RAO) and the wave spectrum at the non-installation position of the strain sensor, and the correction amount, the stress response spectrum at the non-installation position."

The same applies to the following second to eleventh aspects.

(2) An estimation device (monitoring device 10) according to a second aspect is the estimation device of (1), further including: a plate thickness acquisition unit 166 configured to acquire information on a plate thickness of a structure to which a plate thickness sensor is installed, measured by the plate thickness sensor, the plate thickness sensor being installed at a position that is identical to or different from the strain sensor; a plate thickness estimation unit 167 configured to estimate a plate thickness at the non-installation position of the strain sensor based on the plate thickness measured by the plate thickness sensor and a plate thickness at any position measured during an inspection; and an RAO calculation unit 13 configured to calculate the strain response function (RAO) at the non-installation position of the strain sensor by using the plate thickness estimated by the plate thickness estimation unit, in which the RAO acquisition unit 163 acquires the strain response function (RAO) calculated by the RAO calculation unit 13, and the strain response spectrum estimation unit 165 calculates the strain response spectrum based on the strain response function (RAO) acquired.

The plate thickness estimation unit 167 estimates the plate thickness while taking into consideration the thinning due to corrosion at the non-installation position of the strain sensor, and the RAO calculation unit 13 recalculates the strain response function (RAO) based on this plate thickness estimated value. Thus, enhanced accuracy of the strain response spectrum estimated by the strain response spectrum estimation unit 165 can be expected. The latest plate thickness measured by the plate thickness sensor 26 is used for recalculating the strain response function (RAO) and for recalculating the strain response spectrum. Thus, the current strain response spectrum at the strain sensor non-installation position can be estimated with high accuracy. Every time the latest measurement value measured by the plate thickness sensor is obtained, the plate thickness estimation unit 167 estimates the plate thickness at the non-installation position of the strain sensor. By using this result for performing estimation of the strain response spectrum, it is possible to figure out transition of the strain response spectrum at the strain sensor non-installation position.

(3) An estimation device (monitoring device 10) according to a third aspect is the estimation device of (2), in which the plate thickness acquisition unit 166 acquires information on a plate thickness measured by the plate thickness sensor installed on an upper deck of the floating structure, and the plate thickness estimation unit 167 estimates the plate thickness at the non-installation position, based on a relationship between a thinning amount of the upper deck and a thinning amount of the structure at the non-installation position.

The plate thickness sensor is installed on the upper deck where the plate thickness sensor can be easily installed. Based on a relationship (association) between the thinning amount of the upper deck measured by the plate thickness sensor and the thinning amount at an estimation target position (for example, a strain sensor non-installation position), the plate thickness of the estimation target position is estimated, whereby information on the plate thickness of the upper deck can be acquired from the plate thickness sensor. Thus, the plate thickness of the estimation target position, where the plate thickness sensor cannot be attached, can be estimated.

(4) An estimation device (monitoring device 10) according to a fourth aspect is the estimation device of (1) to (3), in which the correction amount calculation unit calculates a correction amount for correcting a difference in a peak position (L), a correction amount for correcting a difference in a peak value (K), and a correction amount for correcting a difference in a distribution width (S) between a waveform expressing a frequency distribution of a strain response spectrum indicated by the theoretical value of the strain response spectrum and a waveform expressing a frequency distribution of a strain response spectrum indicated by the strain response spectrum at the installation position of the strain sensor.

With this configuration, the correction amount for the strain response spectrum indicating the frequency distribution of the stress can be calculated.

(5) An estimation device (monitoring device 10) according to a fifth aspect is the estimation device of (1) to (4), in which the correction amount calculation unit calculates the correction amount corresponding to each of different positions of the floating structure.

For example, a difference between the theoretical value and the measurement value of the strain response spectrum differs among the front, rear, and middle of the ship. By calculating the correction amount for each position, the strain response spectrum can be estimated with high accuracy.

(6) An estimation device (monitoring device 10) according to a sixth aspect is the estimation device of (1) to (5), in which the correction amount calculation unit calculates the correction amount for each wave condition indicated by the wave spectrum at a position where the floating structure is located.

For example, when a condition (wave direction, frequency) of the wave received by the floating structure changes, the difference between the theoretical value and the measurement value of the strain response spectrum changes even at the same position. By calculating the correction amount for each condition (wave spectrum) of the wave, the strain response spectrum can be estimated with high accuracy.

(7) An estimation device (monitoring device 10) according to a seventh aspect is the estimation device of (1) to (6), in which the correction amount calculation unit calculates the correction amount for each property of a member of the floating structure.

The difference between the theoretical value and the measurement value of the strain response spectrum differs when the properties of members (a plate structure, a bone structure, an intersection between bones, and the like) differ even at near positions. By calculating the correction amount in accordance with the property of the member, the strain response spectrum can be estimated with high accuracy.

(8) An estimation device (monitoring device 10) according to an eighth aspect is the estimation device of (4), in which the correction amount calculation unit uses a Bayesian network to model a relationship among the correction amount L for correcting the difference in the peak position, the correction amount K for correcting the difference in the peak value, the correction amount S for correcting the difference in the distribution width, the strain response function (RAO) (301), the wave spectrum (302), a function (315 to 317) that outputs the theoretical value of the strain response spectrum calculated from the strain response function (RAO) and the wave spectrum, the strain response spectrum (318 to 320) after correction obtained by correcting the theoretical value of the strain response spectrum using the correction amount L, the correction amount K, and the correction amount S, and a measured value (324 to 325) of the strain response spectrum calculated based on a value measured by the strain sensor, and calculates the correction amount L, the correction amount K, and the correction amount S through back analysis based on the measured value of the strain response spectrum.

A large number of measured values of the strain response spectrum are prepared, and the correction amount L, the correction amount K, and the correction amount S are calculated, whereby the correction amounts can be calculated with high accuracy.

(9) An estimation device (monitoring device 10) according to a ninth aspect is the estimation device of (1) to (8), further including a degradation estimation unit 168 configured to estimate remaining service life of the structure at the non-installation position of the strain sensor based on the strain response spectrum at the non-installation position estimated by the strain response spectrum estimation unit, and an SN diagram.

By using the strain response spectrum at the non-installation position of the strain sensor estimated by the strain response spectrum estimation unit 165, the remaining service life of the structure at the non-installation position of the strain sensor can be estimated with high accuracy.

(10) An estimation method according to a tenth aspect includes: acquiring a strain response spectrum at an installation position at which a strain sensor is installed on a floating structure, the strain response spectrum being calculated based on a measurement value from the strain sensor; acquiring a wave spectrum of a wave at a position where the floating structure is located; acquiring a strain response function (response amplitude operator (RAO)) at the installation position of the strain sensor and a strain response function (RAO) at a non-installation position of the strain sensor, calculated based on a structure model of the floating structure; calculating, based on the strain response spectrum and the strain response function (RAO) at the installation position of the strain sensor, the wave spectrum, and a formula expressing a relationship among the strain response spectrum and the strain response function (RAO) at the installation position of the strain sensor and the wave spectrum, a correction amount for a difference between a theoretical value of the strain response spectrum at the installation position of the strain sensor calculated from the strain response function (RAO) and the wave spectrum and the strain response spectrum at the installation position of the strain sensor; and calculating, based on a theoretical value of the strain response spectrum at the non-installation position calculated from the strain response function (RAO) and the wave spectrum at the non-installation position of the strain sensor, and the correction amount, the strain response spectrum at the non-installation position.

(11) A program according to an eleventh aspect causes a computer 900 to execute processing including: acquiring a strain response spectrum at an installation position at which a strain sensor is installed on a floating structure, the strain response spectrum being calculated based on a measurement value from the strain sensor; acquiring a wave spectrum of a wave at a position where the floating structure is located; acquiring a strain response function (response amplitude operator (RAO)) at the installation position of the strain sensor and a strain response function (RAO) at a non-installation position of the strain sensor, calculated based on a structure model of the floating structure; calculating, based on the strain response spectrum and the strain response function (RAO) at the installation position of the strain sensor, the wave spectrum, and a formula expressing a relationship among the strain response spectrum and the strain response function (RAO) at the installation position of the strain sensor and the wave spectrum, a correction amount for a difference between a theoretical value of the strain response spectrum at the installation position of the strain sensor calculated from the strain response function (RAO) and the wave spectrum and the strain response spectrum at the installation position of the strain sensor; and calculating, based on a theoretical value of the strain response spectrum at the non-installation position calculated from the strain response function (RAO) and the wave spectrum at the non-installation position of the strain sensor, and the correction amount, the strain response spectrum at the non-installation position.

Industrial Applicability

The estimation device, the estimation method, and the program described above enable estimation of a response at a position where a sensor that detects a structural response is not installed.

Reference Signs List

10 Monitoring device
11 Data acquisition unit
12 Strain response spectrum calculation unit
13 RAO Calculation unit
14 Storage unit
15 Output unit
16 Estimation unit
161 Strain response spectrum acquisition unit
162 Wave spectrum acquisition unit
163 RAO acquisition unit
164 Correction amount calculation unit
165 Strain response spectrum estimation unit
166 Plate thickness acquisition unit
167 Plate thickness estimation unit
168 Degradation estimation unit
900 Computer
901 CPU
902 Main storage device
903 Auxiliary storage device
904 Input/output interface
905 Communication interface

**Claims**

1. An estimation device comprising:

   a strain response spectrum acquisition unit (161) configured to acquire a strain response spectrum at an installation position (23 - 25) at which a strain sensor is installed on a floating structure, the strain response spectrum being calculated based on a measurement value from the strain sensor;
   a wave spectrum acquisition unit (162) configured to acquire a wave spectrum of a wave at a position where the floating structure is located;
   a RAO acquisition unit (163) configured to acquire a strain response function (response amplitude operator (RAO)) at the installation position (23 - 25) of the strain sensor and a strain response function (RAO) at a non-installation position (30) of the strain sensor, calculated based on a structure model of the floating structure;
   a correction amount calculation unit (164) configured to calculate, based on the strain response spectrum and the strain response function (RAO) at the installation position (23 - 25) of the strain sensor, the wave spectrum, and a formula expressing a relationship among the strain response spectrum and the strain response function (RAO) at the installation position (23 - 25) of the strain sensor and the wave spectrum, a correction amount for a difference between a theoretical value of the strain response spectrum at the installation position of the strain sensor calculated from the strain response function (RAO) and the wave spectrum and the strain response spectrum at the installation position of the strain sensor;
   a strain response spectrum estimation unit (165) configured to estimate, based on a theoretical value of the strain response spectrum at the non-installation position (30) calculated from the strain response function (RAO) and the wave spectrum at the non-installation position of the strain sensor, and the correction amount, the strain response spectrum at the non-installation position, **characterized by** comprising:

      a plate thickness acquisition unit (166) configured to acquire information on a plate thickness of a structure to which a plate thickness sensor is installed, measured by the plate thickness sensor, the plate thickness sensor being installed at a position that is identical to or different from the strain sensor;
      a plate thickness estimation unit (167) configured to estimate a plate thickness at the non-installation position of the strain sensor based on the plate thickness measured by the plate thickness sensor and a plate thickness at any position measured during an inspection; and
      a RAO calculation unit (13) configured to calculate the strain response function (RAO) at the non-installation position of the strain sensor by using the plate thickness estimated by the plate thickness estimation unit, wherein
      the RAO acquisition unit (163) is configured to acquire the strain response function (RAO) calculated by the RAO calculation unit, and
      the strain response spectrum estimation unit (165) is configured to calculate the strain response spectrum based on the strain response function (RAO) acquired.

2. The estimation device according to claim 1, wherein

   the plate thickness acquisition unit (166) is configured to acquire information on a plate thickness measured by the plate thickness sensor installed on an upper deck of the floating structure, and
   the plate thickness estimation unit (167) is configured to estimate the plate thickness at the non-installation position, based on a relationship between a thinning amount of the plate thickness of the upper deck and a thinning amount of the structure at the non-installation position (30).

3. The estimation device according to claim 1 or 2, wherein the correction amount calculation unit (164) is configured to calculate a correction amount for correcting a difference in a peak position, a correction amount for correcting a difference in a peak value, and a correction amount for correcting a difference in a distribution width between a waveform expressing a frequency distribution of a strain response spectrum indicated by the theoretical value of the strain response spectrum and a waveform expressing a frequency distribution of a strain response spectrum indicated by the strain response spectrum at the installation position of the strain sensor.

4. The estimation device according to any one of claims 1 to 3, wherein the correction amount calculation unit (164) is configured to calculate the correction amount corresponding to each of different positions of the floating structure.

5. The estimation device according to any one of claims 1 to 4, wherein the correction amount calculation unit (164) is configured to calculate the correction amount for each wave condition indicated by the wave spectrum at a position where the floating structure is located.

6. The estimation device according to any one of claims 1 to 5, wherein the correction amount calculation unit (164) is configured to calculate the correction amount for each property of a member of the floating structure.

7. The estimation device according to claim 3, wherein the correction amount calculation unit (164) is configured to use a Bayesian network to model a relationship among the correction amount L for correcting the difference in the peak position, the correction amount K for correcting the difference in the peak value, the correction amount S for correcting the difference in the distribution width, the strain response function (RAO), the wave spectrum, a function that outputs the theoretical value of the strain response spectrum calculated from the strain response function (RAO) and the wave spectrum, the strain response spectrum after correction obtained by correcting the theoretical value of the strain response spectrum using the correction amount L, the correction amount K, and the correction amount S, and a measured value of the strain response spectrum calculated based on a value measured by the strain sensor, and is configured to calculate the correction amount L, the correction amount K, and the correction amount S through back analysis based on the measured value of the strain response spectrum.

8. The estimation device according to any one of claims 1 to 7, further comprising a degradation estimation unit (168) configured to estimate remaining service life of the structure at the non-installation position (30) of the strain sensor based on the strain response spectrum at the non-installation position estimated by the strain response spectrum estimation unit, and an SN diagram.

9. An estimation method comprising:

acquiring a strain response spectrum at an installation position (23 -25) at which a strain sensor is installed on a floating structure, the strain response spectrum being calculated based on a measurement value from the strain sensor;

acquiring a wave spectrum of a wave at a position where the floating structure is located;

acquiring a strain response function (response amplitude operator (RAO)) at the installation position (23 -25) of the strain sensor and a strain response function (RAO) at a non-installation position (30) of the strain sensor, calculated based on a structure model of the floating structure;

calculating, based on the strain response spectrum and the strain response function (RAO) at the installation position of the strain sensor, the wave spectrum, and a formula expressing a relationship among the strain response spectrum and the strain response function (RAO) at the installation position of the strain sensor and the wave spectrum, a correction amount for a difference between a theoretical value of the strain response spectrum at the installation position of the strain sensor calculated from the strain response function (RAO) and the wave spectrum and the strain response spectrum at the installation position (23 -25) of the strain sensor;

calculating, based on a theoretical value of the strain response spectrum at the non-installation position (30) calculated from the strain response function (RAO) and the wave spectrum at the non-installation position of the strain sensor, and the correction amount, the strain response spectrum at the non-installation position (30);

acquiring information on a plate thickness of a structure to which a plate thickness sensor is installed, measured by the plate thickness sensor, the plate thickness sensor being installed at a position that is identical to or different from the strain sensor;

estimating a plate thickness at the non-installation position of the strain sensor based on the plate thickness measured by the plate thickness sensor and a plate thickness at any position measured during an inspection;

calculating the strain response function (RAO) at the non-installation position of the strain sensor by using the plate thickness estimated;

acquiring the strain response function (RAO) calculated; and

calculating the strain response spectrum based on the strain response function (RAO) acquired.

10. A program for causing a computer (900) to execute processing comprising:

acquiring a strain response spectrum at an installation position at which a strain sensor is installed on a floating structure, the strain response spectrum being calculated based on a measurement value from the strain sensor;

acquiring a wave spectrum of a wave at a position where the floating structure is located;

acquiring a strain response function (response amplitude operator (RAO)) at the installation position of the strain sensor and a strain response function (RAO) at a non-installation position of the strain sensor, calculated based on a structure model of the floating structure;

calculating, based on the strain response spectrum and the strain response function (RAO) at the installation position of the strain sensor, the wave spectrum, and a formula expressing a relationship among the strain response spectrum and the strain response function (RAO) at the installation position of the strain sensor and the wave spectrum, a correction amount for a difference between a theoretical value of the strain response spectrum at the installation position of the strain sensor calculated from the strain response function (RAO) and the wave spectrum and the strain response spectrum at the installation position of the strain sensor;

calculating, based on a theoretical value of the strain response spectrum at the non-installation position calculated from the strain response function (RAO) and the wave spectrum at the non-installation position of the strain sensor, and the correction amount, the strain response spectrum at the non-installation position;

acquiring information on a plate thickness of a structure to which a plate thickness sensor is installed, measured by the plate thickness sensor, the plate thickness sensor being installed at a position that is identical to or different from the strain sensor;

estimating a plate thickness at the non-installation position of the strain sensor based on the plate thickness measured by the plate thickness sensor and a plate thickness at any position measured during an inspection;

calculating the strain response function (RAO) at the non-installation position of the strain sensor by using the plate thickness estimated;

acquiring the strain response function (RAO) calculated; and

calculating the strain response spectrum based on the strain response function (RAO) acquired.

## Patentansprüche

1.  Schätzungsvorrichtung, umfassend:

    eine Dehnungsantwortspektrum-Erfassungseinheit (161), die dazu konfiguriert ist, ein Dehnungsantwortspektrum an einer Installationsposition (23 - 25) zu erfassen, an der ein Dehnungssensor an einer beweglichen Struktur installiert wird, wobei das Dehnungsantwortspektrum basierend auf einem Messwert von dem Dehnungssensor berechnet wird;

    eine Wellenspektrum-Erfassungseinheit (162), die dazu konfiguriert ist, ein Wellenspektrum einer Welle an einer Position zu erfassen, an der sich die bewegliche Struktur befindet;

    eine RAO-Erfassungseinheit (163), die dazu konfiguriert ist, eine Dehnungsantwortfunktion (Antwortamplitudenoperator (RAO)) an der Installationsposition (23-25) des Dehnungssensors und eine Dehnungsantwortfunktion (RAO) an einer Nicht-Installationsposition (30) des Dehnungssensors zu erfassen, die basierend auf einem Strukturmodell der beweglichen Struktur berechnet wird;

    eine Korrekturmaß-Berechnungseinheit (164), die dazu konfiguriert ist, basierend auf dem Dehnungsantwortspektrum und der Dehnungsantwortfunktion (RAO) an der Installationsposition (23 - 25) des Dehnungssensors, dem Wellenspektrum und einer Formel, die eine Beziehung zwischen dem Dehnungsantwortspektrum und der Dehnungsantwortfunktion (RAO) an der Installationsposition (23 - 25) des Dehnungssensors und dem Wellenspektrum ausdrückt ein Korrekturmaß für eine Differenz zwischen einem theoretischen Wert des Dehnungsantwortspektrums an der Installationsposition des Dehnungssensors, der aus der Dehnungsantwortfunktion (RAO) und dem Wellenspektrum berechnet wird, und dem Dehnungsantwortspektrum an der Installationsposition des Dehnungssensors, zu berechnen;

    eine Dehnungsantwortspektrum-Schätzungseinheit (165), die dazu konfiguriert ist, basierend auf einem theoretischen Wertes des Dehnungsantwortspektrums an der Nicht-Installationsposition (30), der aus der Dehnungsantwortfunktion (RAO) und dem Wellenspektrum an der Nicht-Installationsposition des Dehnungssensors berechnet wird, und dem Korrekturmaß, das Dehnungsantwortspektrum an der Nicht-Installationsposition zu schätzen, **dadurch gekennzeichnet, dass** sie umfasst:

    eine Plattendicke-Erfassungseinheit (166), die dazu konfiguriert ist, Informationen über eine Plattendicke einer Struktur zu erfassen, an der ein Plattendicke-Sensor installiert wird, die von dem Plattendicke-Sensor gemessen wird, wobei der Plattendicke-Sensor an einer Position installiert wird, die identisch oder verschieden von dem Dehnungssensor ist;

    eine Plattendicke-Schätzungseinheit (167), die dazu konfiguriert ist, eine Plattendicke an der Nicht-Installationsposition des Dehnungssensors basierend auf die Plattendicke, die von dem Plattendicke-Sensor gemessen wird, und eine Plattendicke an einer beliebigen Position, die während einer Inspektion gemessen wird, zu schätzen; und

    eine RAO-Berechnungseinheit (13), die dazu konfiguriert ist, die Dehnungsantwortfunktion (RAO) an der Nicht-Installationsposition des Dehnungssensors durch Verwenden der Plattendicke zu berechnen, die der von der Plattendicke-Schätzungseinheit geschätzt wurde, wobei

die RAO-Erfassungseinheit (163) dazu konfiguriert ist, die Dehnungsantwortfunktion (RAO), die von der RAO-Berechnungseinheit berechnet wurde, zu erfassen, und

die Dehnungsantwortspektrum-Schätzungseinheit (165) dazu konfiguriert ist, das Dehnungsantwortspektrum basierend auf der erfassten Dehnungsantwortfunktion (RAO) zu berechnen.

2. Schätzungsvorrichtung nach Anspruch 1, wobei

die Plattendicke-Erfassungseinheit (166) dazu konfiguriert ist, Informationen über eine Plattendicke zu erfassen, die von dem Plattendicke-Sensor gemessen wird, der auf einer Oberabdeckung der beweglichen Struktur installiert wird, und

die Plattendicke-Schätzungseinheit (167) dazu konfiguriert ist, die Plattendicke an der Nicht-Installationsposition basierend auf einer Beziehung zwischen einem Verdünnungsmaß der Plattenddicke der Oberabdeckung und einem Verdünnungsmaß der Struktur an der Nicht-Installationsposition (30)zu schätzen.

3. Schätzungsvorrichtung nach Anspruch 1 oder 2, wobei die Korrekturmaß-Berechnungseinheit (164) dazu konfiguriert ist, ein Korrekturmaß zum Korrigieren einer Differenz in einer Spitzenposition, ein Korrekturmaß zum Korrigieren einer Differenz in einem Spitzenwert und ein Korrekturmaß zum Korrigieren einer Differenz in einer Verteilungsbreite zwischen einer Wellenform, die eine Frequenzverteilung eines Dehnungsantwortspektrums ausdrückt, das durch den theoretischen Wert des Dehnungsantwortspektrums angezeigt wird, und einer Wellenform, die eine Frequenzverteilung eines Dehnungsantwortspektrums ausdrückt, das durch das Dehnungsantwortspektrum an der Installationsposition des Dehnungssensors angezeigt wird, zu berechnen.

4. Schätzungsvorrichtung nach einem der Ansprüche 1 bis 3, wobei die Korrekturmaß-Berechnungseinheit (164) dazu konfiguriert ist, das Korrekturmaß, das jeder der verschiedenen Positionen der schwimmenden Struktur entspricht, zu berechnen.

5. Schätzungsvorrichtung nach einem der Ansprüche 1 bis 4, wobei die Korrekturmaß-Berechnungseinheit (164) dazu konfiguriert ist, das Korrekturmaß für jeden Wellenzustand zu berechnen, der durch das Wellenspektrum an einer Position angezeigt wird, an der sich die bewegliche Struktur befindet.

6. Schätzungsvorrichtung nach einem der Ansprüche 1 bis 5, wobei die Korrekturmaß-Berechnungseinheit (164) dazu konfiguriert ist, das Korrekturmaß für jede Eigenschaft eines Elements der beweglichen Struktur zu berechnen.

7. Schätzungsvorrichtung nach Anspruch 3, wobei die Korrekturmaß-Berechnungseinheit (164) dazu konfiguriert ist, ein Bayesian Netzwerk zu verwenden, um eine Beziehung zwischen dem Korrekturmaß L zum Korrigieren der Differenz in der Spitzenposition, dem Korrekturmaß K zum Korrigieren der Differenz in dem Spitzenwert, dem Korrekturmaß S zum Korrigieren der Differenz in der Verteilungsbreite, der Dehnungsantwortfunktion (RAO), dem Wellenspektrum, einer Funktion, die den theoretischen Wert des Dehnungsantwortspektrums ausgibt, der aus der Dehnungsantwortfunktion (RAO) und dem Wellenspektrum berechnet wird, dem Dehnungsantwortspektrum nach der Korrektur, das durch Korrigieren des theoretischen Wertes des Dehnungsantwortspektrums durch Verwenden des Korrekturmaßes L, des Korrekturmaßes K und des Korrekturmaßes S erhalten wird, und einem gemessenen Wert des Dehnungsantwortspektrums, das basierend auf einem durch den Dehnungssensor gemessenen Wert berechnet wird, darzustellen und dazu konfiguriert ist, das Korrekturmaß L, das Korrekturmaß K und das Korrekturmaß S durch Rückanalyse basierend auf dem gemessenen Wert des Dehnungsantwortspektrums zu berechnen.

8. Schätzungsvorrichtung nach einem der Ansprüche 1 bis 7, ferner umfassend eine Degradierungsschätzungseinheit (168), die dazu konfiguriert ist, die verbleibende Lebensdauer der Struktur an der Nicht-Installationsposition (30) des Dehnungssensors basierend auf dem Dehnungsantwortspektrum an der Nicht-Installationsposition, das von der Dehnungsantwortspektrum-Schätzungseinheit geschätzt wird, und einem SN-Diagramm zu schätzen.

9. Schätzungsverfahren, umfassend:

Erfassen eines Dehnungsantwortspektrums an einer Installationsposition (23 - 25), an der ein Dehnungssensor an einer beweglichen Struktur installiert wird, wobei das Dehnungsantwortspektrum basierend auf einem Messwert von dem Dehnungssensor berechnet wird;

Erfassen eines Wellenspektrums einer Welle an einer Position, an der sich die bewegliche Struktur befindet;

Erfassen einer Dehnungsantwortfunktion (Antwortamplitudenoperator (RAO)) an der Installationsposition (23 - 25) des Dehnungssensors und einer Dehnungsantwortfunktion (RAO) an einer Nicht-Installationsposition (30) des Dehnungssensors, die basierend auf einem Strukturmodell der beweglichen Struktur berechnet werden;
Berechnen, basierend auf dem Dehnungsantwortspektrum und der Dehnungsantwortfunktion (RAO) an der Installationsposition des Dehnungssensors, des Wellenspektrums und einer Formel, die eine Beziehung zwischen dem Dehnungsantwortspektrum und der Dehnungsantwortfunktion (RAO) an der Installationsposition des Dehnungssensors und dem Wellenspektrum ausdrückt, eines Korrekturmaßes für eine Differenz zwischen einem theoretischen Wert des Dehnungsantwortspektrums an der Installationsposition des Dehnungssensors, der aus der Dehnungsantwortfunktion (RAO) und dem Wellenspektrum berechnet wird, und dem Dehnungsantwortspektrum an der Installationsposition (23 - 25) des Dehnungssensors;
Berechnen des Dehnungsantwortspektrums an der Nicht-Installationsposition (30) basierend auf einem theoretischen Wert des Dehnungsantwortspektrums an der Nicht-Installationsposition (30), der aus der Dehnungsantwortfunktion (RAO) und dem Wellenspektrum an der Nicht-Installationsposition des Dehnungssensors berechnet wird, und dem Korrekturmaß;
Erfassen Informationen über eine Plattendicke einer Struktur, an der ein Plattendicke-Sensor installiert wird, die durch den Plattendicke-Sensor gemessen wird, wobei der Plattendicke-Sensor an einer Position installiert wird, die identisch oder verschieden von dem Dehnungssensor ist;
Schätzen einer Plattendicke an der Nicht-Installationsposition des Dehnungssensors basierend auf der Plattendicke, die von dem Plattendicke-Sensor gemessen wird und einer Plattendicke an einer beliebigen Position, die während einer Inspektion gemessen wird;
Berechnen der Dehnungsantwortfunktion (RAO) an der Nicht-Installationsposition des Dehnungssensors durch Verwenden der geschätzten Plattendicke;
Erfassen der berechneten Dehnungsantwortfunktion (RAO); und
Berechnen des Dehnungsantwortspektrums basierend auf der erfassten Dehnungsantwortfunktion (RAO).

**10.** Programm, das einen Computer (900) veranlasst, eine Verarbeitung auszuführen, umfassend:

Erfassen eines Dehnungsantwortspektrums an einer Installationsposition, an der ein Dehnungssensor an einer beweglichen Struktur installiert wird, wobei das Dehnungsantwortspektrum basierend auf einem Messwerts von dem Dehnungssensor berechnet wird;
Erfassen eines Wellenspektrums einer Welle an einer Position, an der sich die bewegliche Struktur befindet;
Erfassen einer Dehnungsantwortfunktion (Antwortamplitudenoperator (RAO)) an der Installationsposition des Dehnungssensors und einer Dehnungsantwortfunktion (RAO) an einer Nicht-Installationsposition des Dehnungssensors, die basierend auf einem Strukturmodell der beweglichen Struktur berechnet wird;
Berechnen, basierend auf dem Dehnungsantwortspektrum und der Dehnungsantwortfunktion (RAO) an der Installationsposition des Dehnungssensors, dem Wellenspektrum und einer Formel, die eine Beziehung zwischen dem Dehnungsantwortspektrum und der Dehnungsantwortfunktion (RAO) an der Installationsposition des Dehnungssensors und dem Wellenspektrum ausdrückt, eines Korrekturmaßes für eine Differenz zwischen einem theoretischen Wert des Dehnungsantwortspektrums an der Installationsposition des Dehnungssensors, der aus der Dehnungsantwortfunktion (RAO) und dem Wellenspektrum berechnet wird, und dem Wellenspektrum und dem Dehnungsantwortspektrum an der Installationsposition des Dehnungssensors;
Berechnen, basierend auf einem theoretischen Wert des Dehnungsantwortspektrums an der Nicht-Installationsposition, der aus der Dehnungsantwortfunktion (RAO) und dem Wellenspektrum an der Nicht-Installationsposition des Dehnungssensors berechnet wird und dem Korrekturmaß, des Dehnungsantwortspektrums an der Nicht-Installationsposition;
Erfassen Informationen über eine Plattendicke einer Struktur, an der ein Plattendicke-Sensor installiert wird, die durch den Plattendicke-Sensor gemessen wird, wobei der Plattendicke-Sensor an einer Position installiert wird, die identisch oder verschieden von dem Dehnungssensor ist;
Schätzen einer Plattendicke an der Nicht-Installationsposition des Dehnungssensors basierend auf der Plattendicke, die von dem Plattendicke-Sensor gemessen wird und einer Plattendicke an einer beliebigen Position, die während einer Inspektion gemessen wird;
Berechnen der Dehnungsantwortfunktion (RAO) an der Nicht-Installationsposition des Dehnungssensors durch Verwenden der geschätzten Plattendicke;
Erfassen der berechneten Dehnungsantwortfunktion (RAO); und
Berechnen des Dehnungsantwortspektrums basierend auf der erfassten Dehnungsantwortfunktion (RAO).

**Revendications**

**1.** Dispositif d'estimation comprenant :

une unité d'acquisition du spectre de réponse de distorsion (161) configurée pour acquérir un spectre de réponse de distorsion à une position d'installation (23 - 25) à laquelle un capteur de distorsion est installé sur une structure flottante, le spectre de réponse de distorsion étant calculé à partir d'une valeur de mesure provenant du capteur de distorsion ;

une unité d'acquisition de spectre d'ondes (162) configurée pour acquérir un spectre d'ondes d'une onde à une position où la structure flottante est située ;

une unité d'acquisition RAO (163) configurée pour acquérir une fonction de réponse de distorsion (opérateur d'amplitude de réponse (RAO)) à la position d'installation (23 - 25) du capteur de distorsion et une fonction de réponse de distorsion (RAO) à une position de non-installation (30) du capteur de distorsion, calculée à partir d'un modèle de structure de la structure flottante ;

une unité de calcul du montant de la correction (164) configurée pour calculer, à partir du spectre de réponse de distorsion et de la fonction de réponse de distorsion (RAO) à la position d'installation (23 - 25) du capteur de distorsion, le spectre d'ondes, et une formule exprimant une relation entre le spectre de réponse de distorsion et la fonction de réponse de distorsion (RAO) à la position d'installation (23 - 25) du capteur de distorsion et du spectre d'ondes, un montant de correction pour une différence entre une valeur théorique du spectre de réponse de distorsion à la position d'installation du capteur de distorsion calculée à partir de la fonction de réponse de distorsion (RAO) et du spectre d'ondes et du spectre de réponse de distorsion à la position d'installation du capteur de distorsion ;

une unité d'estimation du spectre de réponse de distorsion (165) configurée pour estimer, à partir d'une valeur théorique du spectre de réponse de distorsion à la position de non-installation (30) calculée à partir de la fonction de réponse de distorsion (RAO) et du spectre d'ondes à la position de non-installation du capteur de distorsion, et de la quantité de correction, le spectre de réponse de distorsion à la position de non-installation, **caractérisé en ce qu'**il comprend :

une unité d'acquisition de l'épaisseur de la plaque (166) configurée pour acquérir des informations sur l'épaisseur de la plaque d'une structure sur laquelle est installé un capteur d'épaisseur de la plaque, mesurée par le capteur d'épaisseur de la plaque, le capteur d'épaisseur de la plaque étant installé à une position identique ou différente du capteur de distorsion ;

une unité d'estimation de l'épaisseur de la plaque (167) configurée pour estimer l'épaisseur de la plaque à la position de non-installation du capteur de distorsion à partir de l'épaisseur de la plaque mesurée par le capteur d'épaisseur de la plaque et de l'épaisseur de la plaque à une position quelconque mesurée au cours d'une inspection ; et

une unité de calcul RAO (13) configurée pour calculer la fonction de réponse de distorsion (RAO) à la position de non-installation du capteur de distorsion en utilisant l'épaisseur de la plaque estimée par l'unité d'estimation de l'épaisseur de la plaque, dans lequel

l'unité d'acquisition RAO (163) est configurée pour acquérir la fonction de réponse de distorsion (RAO) calculée par l'unité de calcul RAO, et

l'unité d'estimation du spectre de réponse de distorsion (165) est configurée pour calculer le spectre de réponse de distorsion à partir de la fonction de réponse de distorsion (RAO) acquise.

2. Dispositif d'estimation selon la revendication 1, dans lequel

l'unité d'acquisition de l'épaisseur de la plaque (166) est configurée pour acquérir des informations sur l'épaisseur de la plaque mesurée par le capteur d'épaisseur de la plaque installé sur un niveau supérieur de la structure flottante, et

l'unité d'estimation de l'épaisseur de la plaque (167) est configurée pour estimer l'épaisseur de la plaque à la position de non-installation, à partir d'une relation entre un amincissement de l'épaisseur de la plaque du niveau supérieur et un amincissement de la structure à la position de non-installation (30) .

3. Dispositif d'estimation selon la revendication 1 ou 2, dans lequel l'unité de calcul du montant de la correction (164) est configurée pour calculer un montant de correction pour corriger une différence dans une position de crête, un montant de correction pour corriger une différence dans une valeur de crête, et un montant de correction pour corriger une différence dans une largeur de distribution entre une forme d'onde exprimant une distribution de fréquence d'un spectre de réponse de distorsion indiqué par la valeur théorique du spectre de réponse de distorsion et une forme d'onde exprimant une distribution de fréquence d'un spectre de réponse de distorsion indiqué par le spectre de réponse de distorsion à la position d'installation du capteur de distorsion.

4. Dispositif d'estimation selon l'une des revendications 1 à 3, dans lequel l'unité de calcul du montant de la correction (164) est configurée pour calculer le montant de la correction correspondant à chacune des différentes positions de la structure flottante.

5. Dispositif d'estimation selon l'une des revendications 1 à 4, dans lequel l'unité de calcul du montant de la correction (164) est configurée pour calculer le montant de la correction pour chaque condition d'onde indiquée par le spectre d'ondes à une position où la structure flottante est située.

6. Dispositif d'estimation selon l'une des revendications 1 à 5, dans lequel l'unité de calcul du montant de la correction (164) est configurée pour calculer le montant de la correction pour chaque propriété d'un élément de la structure flottante.

7. Dispositif d'estimation selon la revendication 3, dans lequel l'unité de calcul du montant de la correction (164) est configurée pour utiliser un réseau bayésien pour modéliser une relation entre le montant de la correction L afin de corriger la différence dans la position de crête, le montant de la correction K pour corriger la différence dans la valeur de crête, le montant de la correction S pour corriger la différence dans la largeur de distribution, la fonction de réponse de distorsion (RAO), le spectre d'ondes, une fonction qui délivre la valeur théorique du spectre de réponse de distorsion calculée à partir de la fonction de réponse de distorsion (RAO) et du spectre d'ondes, le spectre de réponse de distorsion après correction obtenu en corrigeant la valeur théorique du spectre de réponse de distorsion en utilisant le montant de correction L, le montant de correction K et le montant de correction S, et une valeur mesurée du spectre de réponse aux distorsions calculée à partir d'une valeur mesurée par le capteur de distorsion, et est configuré pour calculer le montant de correction L, le montant de correction K et le montant de correction S par rétroanalyse à partir de la valeur mesurée du spectre de réponse de distorsion.

8. Dispositif d'estimation selon l'une des revendications 1 à 7, comprenant en outre une unité d'estimation de la dégradation (168) configurée pour estimer la durée de vie restante de la structure à la position de non-installation (30) du capteur de distorsion à partir du spectre de réponse de distorsion à la position de non-installation estimé par l'unité d'estimation du spectre de réponse de distorsion, et d'un diagramme SN.

9. Procédé d'estimation consistant à :

acquérir un spectre de réponse de distorsion à une position d'installation (23 - 25) à laquelle un capteur de distorsion est installé sur une structure flottante, le spectre de réponse de distorsion étant calculé à partir d'une valeur de mesure provenant du capteur de distorsion ;
acquérir un spectre d'ondes d'une onde à une position où la structure flottante est située ;
acquérir une fonction de réponse de distorsion (opérateur d'amplitude de réponse (RAO)) à la position d'installation (23 - 25) du capteur de distorsion et une fonction de réponse de distorsion (RAO) à une position de non-installation (30) du capteur de distorsion, calculée à partir d'un modèle de structure de la structure flottante ;
calculer, à partir du spectre de réponse de distorsion et de la fonction de réponse de distorsion (RAO) à la position d'installation du capteur de distorsion, le spectre d'ondes, et une formule exprimant une relation entre le spectre de réponse de distorsion et la fonction de réponse de distorsion (RAO) à la position d'installation du capteur de distorsion et du spectre d'ondes, un montant de correction pour une différence entre une valeur théorique du spectre de réponse de distorsion à la position d'installation du capteur de distorsion calculée à partir de la fonction de réponse de distorsion (RAO) et du spectre d'ondes et du spectre de réponse de distorsion à la position d'installation (23 - 25) du capteur de distorsion ;
calculer, à partir d'une valeur théorique du spectre de réponse de distorsion à la position de non-installation (30) calculée à partir de la fonction de réponse de distorsion (RAO) et du spectre d'ondes à la position de non-installation du capteur de distorsion, et de la quantité de correction, le spectre de réponse de distorsion à la position de non-installation (30) ;
acquérir des informations sur l'épaisseur de la plaque d'une structure sur laquelle est installé un capteur d'épaisseur de la plaque, mesurée par le capteur d'épaisseur de la plaque, le capteur d'épaisseur de la plaque étant installé à une position identique ou différente du capteur de distorsion ;
estimer l'épaisseur de la plaque à la position de non-installation du capteur de distorsion à partir de l'épaisseur de la plaque mesurée par le capteur d'épaisseur de la plaque et de l'épaisseur de la plaque à une position quelconque mesurée au cours d'une inspection ;
calculer la fonction de réponse de distorsion (RAO) à la position de non-installation du capteur de distorsion en utilisant l'épaisseur estimée de la plaque ;
acquérir la fonction de réponse de distorsion (RAO) calculée ; et

calculer le spectre de réponse de distorsion à partir de la fonction de réponse de distorsion (RAO) acquise.

**10.** Programme pour amener un ordinateur (900) à exécuter un traitement consistant à :

acquérir un spectre de réponse de distorsion à une position d'installation à laquelle un capteur de distorsion est installé sur une structure flottante, le spectre de réponse de distorsion étant calculé à partir d'une valeur de mesure provenant du capteur de distorsion ;

acquérir un spectre d'ondes d'une onde à une position où la structure flottante est située ;

acquérir une fonction de réponse de distorsion (opérateur d'amplitude de réponse (RAO)) à la position d'installation du capteur de distorsion et une fonction de réponse de distorsion (RAO) à une position de non-installation du capteur de distorsion, calculée à partir d'un modèle de structure de la structure flottante ;

calculer, à partir du spectre de réponse de distorsion et de la fonction de réponse de distorsion (RAO) à la position d'installation du capteur de distorsion, le spectre d'ondes, et une formule exprimant une relation entre le spectre de réponse de distorsion et la fonction de réponse de distorsion (RAO) à la position d'installation du capteur de distorsion et du spectre d'ondes, un montant de correction pour une différence entre une valeur théorique du spectre de réponse de distorsion à la position d'installation du capteur de distorsion calculée à partir de la fonction de réponse de distorsion (RAO) et du spectre d'ondes et du spectre de réponse de distorsion à la position d'installation du capteur de distorsion ;

calculer, à partir d'une valeur théorique du spectre de réponse de distorsion à la position de non-installation calculée à partir de la fonction de réponse de distorsion (RAO) et du spectre d'ondes à la position de non-installation du capteur de distorsion, et de la quantité de correction, le spectre de réponse de distorsion à la position de non-installation ;

acquérir des informations sur l'épaisseur de la plaque d'une structure sur laquelle est installé un capteur d'épaisseur de la plaque, mesurée par le capteur d'épaisseur de la plaque, le capteur d'épaisseur de la plaque étant installé à une position identique ou différente du capteur de distorsion ;

estimer l'épaisseur de la plaque à la position de non-installation du capteur de distorsion à partir de l'épaisseur de la plaque mesurée par le capteur d'épaisseur de la plaque et de l'épaisseur de la plaque à une position quelconque mesurée au cours d'une inspection ;

calculer la fonction de réponse de distorsion (RAO) à la position de non-installation du capteur de distorsion en utilisant l'épaisseur estimée de la plaque ;

acquérir la fonction de réponse de distorsion (RAO) calculée ; et

calculer le spectre de réponse de distorsion à partir de la fonction de réponse de distorsion (RAO) acquise.

FIG. 1

# FIG. 2

REGULAR WAVES

# FIG. 3

# FIG. 4A

STRAIN
RESPONSE SPECTRUM

f(ω)

FREQUENCY (ω)

2.5% OF INTEGRATED VALUE  $\omega_L$  S  $\omega_U$  2.5% OF INTEGRATED VALUE

# FIG. 4B

```
                        ┌──────────┐
                        │  START   │
                        └──────────┘
                             │
                             ▼                          ⌐S1
        ┌────────────────────────────────────────────┐
        │          ACQUIRE SENSOR DATA               │
        └────────────────────────────────────────────┘
                             │
                             ▼                          ⌐S2
        ┌────────────────────────────────────────────┐
        │     CALCULATE STRAIN RESPONSE SPECTRUM     │
        │            OF MEASURED POINT               │
        └────────────────────────────────────────────┘
                             │
                             ▼                          ⌐S3
        ┌────────────────────────────────────────────┐
        │   CALCULATE STRAIN RESPONSE FUNCTIONS (RAO)│
        │   OF MEASURED POINT AND UNMEASURED POINT   │
        └────────────────────────────────────────────┘
                             │
                             ▼                          ⌐S4
        ┌────────────────────────────────────────────┐
        │        CREATE FUNCTION FOR CALCULATING     │
        │             CORRECTION AMOUNT              │
        └────────────────────────────────────────────┘
                             │
                             ▼                          ⌐S5
        ┌────────────────────────────────────────────┐
        │       ACQUIRE EVALUATION TARGET DATA       │
        │          AND EVALUATION CONDITION          │
        └────────────────────────────────────────────┘
                             │
                             ▼                          ⌐S6
        ┌────────────────────────────────────────────┐
        │ CALCULATE CORRECTION AMOUNT CORRESPONDING  │
        │           TO EVALUATION CONDITION          │
        └────────────────────────────────────────────┘
                             │
                             ▼                          ⌐S7
        ┌────────────────────────────────────────────┐
        │      ESTIMATE STRAIN RESPONSE SPECTRUM     │
        │            AT UNMEASURED POINT             │
        └────────────────────────────────────────────┘
                             │
                             ▼                          ⌐S8
        ┌────────────────────────────────────────────┐
        │ ESTIMATE FATIGUE LEVEL/REMAINING SERVICE LIFE│
        │            AT UNMEASURED POINT             │
        └────────────────────────────────────────────┘
                             │
                             ▼                          ⌐S9
        ┌────────────────────────────────────────────┐
        │        OUTPUT STRAIN RESPONSE SPECTRUM AND │
        │    FATIGUE LEVEL/REMAINING SERVICE LIFE AT │
        │             UNMEASURED POINT               │
        └────────────────────────────────────────────┘
                             │
                             ▼
                        ┌──────────┐
                        │   END    │
                        └──────────┘
```

# FIG. 5

FIG. 6

FIG. 7

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2020191656 A
- JP 2016166001 A

- WO 2016108183 A1

**Non-patent literature cited in the description**

- Outline of the research project on hull structure health monitoring of 14,000TEU large container ships. **TETSUO OKADA** ; **YASUMI KAWAMURA** ; **ATSUSHI KATO** ; **HIDEYUKI ANDO** ; **TAKESHI YONEZAWA** ; **FUMITAKA KIMURA** ; **MASANOBU TOYODA** ; **AKIHIKO YAMAUCHI** ; **TOSHIRO ARIMA** ; **MASAYOSHI OKA**. Conference proceedings. Japan Society of Naval Architects and Ocean Engineers, 2017, vol. 05, 31-35

- A study on the estimation method of an ocean wave spectrum using measured hull responses on 14,000TEU large container ships. **YUKI YOSHIHIRA** ; **TETSUO OKADA** ; **YASUMI KAWAMURA** ; **YUKI TERADA**. Conference proceedings. Japan Society of Naval Architects and Ocean Engineers, 2017, vol. 05, 37-42